# EUROPEAN PATENT APPLICATION

(11) **EP 4 845 037 A1**
(43) Date of publication of application: **25.11.2026**
(21) Application number: 24918871.5
(22) Date of filing: 16.01.2024
(51) Int. Cl.: H03M 13/13, H03M 13/00, H04L 1/00

(54) **METHOD AND COMMUNICATION DEVICE FOR PERFORMING DECODING, PROCESSING DEVICE, AND STORAGE MEDIUM**

(71) Applicant: LG Electronics Inc., Yeongdeungpo-gu Seoul 07336 (KR); Korea Advanced Institute of Science and Technology, Daejeon 34141 (KR)
(72) Inventor: KIM, Bonghoe, Seoul 06772 (KR); HA, Jeongseok, Daejeon 34200 (KR); PARK, Taehee, Yongin-si, Gyeonggi-do 16941 (KR); HAN, Seokju, Seoul 05380 (KR)
(74) Representative: Mooser, Sebastian Thomas
(86) International application number: PCT/KR2024/000761
(87) International publication number: WO 2025/154836

(57) **Abstract**

This communication device may: receive a signal and acquire a first bit sequence having a length of N from the received signal; generate P number of second bit sequences by applying P number of different permutations to the first bit sequence; and complete decoding only for each of L_{c} number of second bit sequences having uppermost minimum log likelihood ratio (LLR) values that are greater than a predetermined second threshold value among the P number of second bit sequences.

## Description

### TECHNICAL FIELD

The present disclosure relates to a wireless communication system.

### BACKGROUND

A variety of technologies, such as machine-to-machine (M2M) communication, machine type communication (MTC), and a variety of devices demanding high data throughput, such as smartphones and tablet personal computers (PCs), have emerged and spread. Accordingly, the amount of data throughput demanded to be processed in a cellular network has rapidly increased. In order to satisfy such rapidly increasing data throughput, carrier aggregation technologies, cognitive radio technology, and the like for efficiently employing more frequency bands, and multi-antenna technology or multi-base station (BS) cooperation technology, and the like for raising data capacity transmitted on limited frequency resources are advancing.

As more and more communication devices have required greater communication capacity, there has been a need for enhanced mobile broadband (eMBB) communication relative to legacy radio access technology (RAT). In addition, massive machine type communication (mMTC) for providing various services at anytime and anywhere by connecting a plurality of devices and objects to each other is one main issue to be considered in next-generation communication.

Communication system design considering services/user equipment (UEs) sensitive to reliability and latency is also under discussion. The introduction of next-generation RAT is being discussed in consideration of eMBB communication, mMTC, ultra-reliable and low-latency communication (URLLC), and the like.

### DISCLOSURE

### Technical Problem

There is a need for a method for further improving the performance of a polar code proposed as an alternative to existing channel codes. For example, a list successive cancellation decoder used for conventional polar code decoding performs a sorting operation for each bit, and therefore has disadvantages in that implementation complexity and latency are high. Accordingly, there is a need for a method for addressing such issues.

The objects to be achieved with the present disclosure are not limited to what has been particularly described hereinabove and other objects not described herein will be more clearly understood by persons skilled in the art from the following detailed description.

### Technical Solution

In an aspect of the present disclosure, a method for decoding a received signal by a communication device in a wireless communication system is provided. The method may include receiving a bit sequence **y** related to an encoded bit sequence of length N based on a polar code of size N, wherein N is an integer greater than 1, obtaining a first bit sequence of length N from the bit sequence **y**, generating P second bit sequences by applying P different permutations to the first bit sequence, wherein P is an integer greater than 1, performing successive cancellation decoding based on the P second bit sequences, and determining a codeword based on the successive cancellation decoding. Performing the successive cancellation decoding includes completing decoding only for each of L_{c} second bit sequences having largest minimum log likelihood ratio (LLR) values greater than a predetermined second threshold τ₂ among the P second bit sequences, wherein L_{c} is a positive integer smaller than P.

In another aspect of the present disclosure, a communication device for decoding a received signal in a wireless communication system is provided. The communication device includes at least one transceiver, at least one processor, and at least one computer memory operably connectable to the at least one processor and storing instructions which, when executed, cause the at least one processor to perform operations. The operations may include receiving a bit sequence **y** related to an encoded bit sequence of length N based on a polar code of size N, wherein N is an integer greater than 1, obtaining a first bit sequence of length N from the bit sequence **y**, generating P second bit sequences by applying P different permutations to the first bit sequence, wherein P is an integer greater than 1, performing successive cancellation decoding based on the P second bit sequences, and determining a codeword based on the successive cancellation decoding. Performing the successive cancellation decoding includes completing decoding only for each of L_{c} second bit sequences having largest minimum LLR values greater than a predetermined second threshold τ₂ among the P second bit sequences, wherein L_{c} is a positive integer smaller than P.

In another aspect of the present disclosure, a processing device in a wireless communication system is provided. The processing device includes at least one processor, and at least one computer memory operably connectable to the at least one processor and storing instructions which, when executed, cause the at least one processor to perform operations. The operations may include receiving a bit sequence **y** related to an encoded bit sequence of length N based on a polar code of size N, wherein N is an integer greater than 1, obtaining a first bit sequence of length N from the bit sequence **y**, generating P second bit sequences by applying P different permutations to the first bit sequence, wherein P is an integer greater than 1, performing successive cancellation decoding based on the P second bit sequences, and determining a codeword based on the successive cancellation decoding. Performing the successive cancellation decoding includes completing decoding only for each of L_{c} second bit sequences having largest minimum LLR values greater than a predetermined second threshold τ₂ among the P second bit sequences, wherein L_{c} is a positive integer smaller than P.

In another aspect of the present disclosure, a computer-readable storage medium is provided. The storage medium stores at least one program code including instructions which, when executed, cause at least one processor to perform operations. The operations may include receiving a bit sequence **y** related to an encoded bit sequence of length N based on a polar code of size N, wherein N is an integer greater than 1, obtaining a first bit sequence of length N from the bit sequence **y**, generating P second bit sequences by applying P different permutations to the first bit sequence, wherein P is an integer greater than 1, performing successive cancellation decoding based on the P second bit sequences, and determining a codeword based on the successive cancellation decoding. Performing the successive cancellation decoding includes completing decoding only for each of L_{c} second bit sequences having largest minimum LLR values greater than a predetermined second threshold τ₂ among the P second bit sequences, wherein L_{c} is a positive integer smaller than P.

In each aspect of the present disclosure, performing the successive cancellation decoding may include terminating decoding of a second bit sequence before completion of the decoding, when i) a minimum LLR value among LLR values of t least reliable information bits of the second bit sequence is not greater than τ₂, or ii) the second bit sequence does not belong to the L_{c} second bit sequences.

In each aspect of the present disclosure, performing the successive cancellation decoding may include terminating decoding of a second bit sequence including an information bit having an LLR value smaller than a predefined first threshold τ₁, among the P second bit sequences, at the information bit including the LLR value smaller than τ₁.

In each aspect of the present disclosure, performing the successive cancellation decoding may include comparing LLR values of t least reliable information bits in each of the P second bit sequences with τ₁, and terminating decoding of a corresponding second bit sequence at an information bit having an LLR value smaller than τ₁ among the t least reliable information bits.

In each aspect of the present disclosure, the encoded bit sequence may be obtained based on K information bits and the polar code of size N.

In each aspect of the present disclosure, the method may include determining an information bit sequence of length K based on the codeword and a polar sequence of length N that sorts N bit indices of the polar code of length N according to reliability.

In each aspect of the present disclosure, performing the successive cancellation decoding may include outputting L_{c} third bit sequences based on the L_{c} second bit sequences, and outputting, as the codeword, a bit sequence minimizing a distance between the bit sequence **y** and a corresponding third bit sequence among the L_{c} third bit sequences.

The foregoing solutions are merely a part of the examples of the present disclosure and various examples into which the technical features of the present disclosure are incorporated may be derived and understood by persons skilled in the art from the following detailed description.

### Advantageous Effects

According to some implementation(s) of the present disclosure, a wireless communication signal may be efficiently transmitted/received. Accordingly, the total throughput of a wireless communication system may be raised.

According to some implementations of the present disclosure, parallel decoding for polar codes may be enabled. Accordingly, disadvantages of a conventional polar code decoding scheme, in which implementation difficulty increases due to complexity caused by metric sorting, may be overcome.

According to some implementations of the present disclosure, disadvantages of permutation decoding may be overcome.

The effects according to the present disclosure are not limited to what has been particularly described hereinabove and other effects not described herein will be more clearly understood by persons skilled in the art related to the present disclosure from the following detailed description.

### BRIEF DESCRIPTION OF THE DRAWINGS

The accompanying drawings, which are included to provide a further understanding of the present disclosure, illustrate examples of implementations of the present disclosure and together with the detailed description serve to explain implementations of the present disclosure:
FIG. 1 illustrates an example of a communication system 1 to which implementations of the present disclosure are applied;
FIG. 2 is a block diagram illustrating examples of communication devices capable of performing a method according to the present disclosure;
FIG. 3 illustrates another example of a wireless device capable of performing implementation(s) of the present disclosure;
FIG. 4 illustrates an example of a frame structure used in a 3rd generation partnership project (3GPP)-based wireless communication system;
FIG. 5 illustrates a process for processing a transport block (TB) on a transmitting side;
FIG. 6 is an exemplary block diagram for a polar encoder;
FIG. 7 illustrates the concept of channel splitting and channel combining for channel polarization;
FIG. 8 illustrates N-th level channel combining for polar codes;
FIG. 9 illustrates evolution of decoding paths in a list-L decoding process;
FIG. 10 is a diagram to explain the concept of selecting position(s) to which information bit(s) are to be allocated in polar codes;
FIG. 11 illustrates puncturing and information bit allocation for polar codes;
FIG. 12 illustrates an example of a permutation decoder;
FIG. 13 illustrates an exemplary decoding process according to some implementations of the present disclosure;
FIG. 14 illustrates another exemplary decoding process according to some implementations of the present disclosure;
FIG. 15 illustrates changes in minimum log likelihood ratio (LLR) values of respective decoding paths in sequential decoding according to bit indices;
FIGS. 16 and 17 illustrate a method for determining the size of a test region according to some implementations of the present disclosure;
FIGS. 18 to 23 illustrate the error probability of each bit in each code structure;
FIGS. 24 and 25 illustrate the word error rate (WER) and complexity performance of a decoding scheme according to some implementations of the present disclosure;
FIG. 26 illustrates a decoding process according to some implementations of the present disclosure;
FIG. 27 illustrates physical channels used in a 3GPP-based communication system, which is an example of a wireless communication system, and a signal transmission/reception process using the same; and
FIG. 28 illustrates a random access procedure applicable to implementation(s) of the present disclosure.

### DETAILED DESCRIPTION

Hereinafter, implementations according to the present disclosure will be described in detail with reference to the accompanying drawings. The detailed description, which will be given below with reference to the accompanying drawings, is intended to explain exemplary implementations of the present disclosure, rather than to show the only implementations that may be implemented according to the present disclosure. The following detailed description includes specific details in order to provide a thorough understanding of the present disclosure. However, it will be apparent to those skilled in the art that the present disclosure may be practiced without such specific details.

In some instances, known structures and devices may be omitted or may be shown in block diagram form, focusing on important features of the structures and devices, so as not to obscure the concept of the present disclosure. The same reference numbers will be used throughout the present disclosure to refer to the same or like parts.

A technique, a device, and a system described below may be applied to a variety of wireless multiple access systems. The multiple access systems may include, for example, a code division multiple access (CDMA) system, a frequency division multiple access (FDMA) system, a time division multiple access (TDMA) system, an orthogonal frequency division multiple access (OFDMA) system, a single-carrier frequency division multiple access (SC-FDMA) system, a multi-carrier frequency division multiple access (MC-FDMA) system, etc. CDMA may be implemented by radio technology such as universal terrestrial radio access (UTRA) or CDMA2000. TDMA may be implemented by radio technology such as global system for mobile communications (GSM), general packet radio service (GPRS), enhanced data rates for GSM evolution (EDGE) (i.e., GERAN), etc. OFDMA may be implemented by radio technology such as institute of electrical and electronics engineers (IEEE) 802.11 (Wi-Fi), IEEE 802.16 (WiMAX), IEEE 802.20, evolved-UTRA (E-UTRA), etc. UTRA is part of universal mobile telecommunications system (UMTS) and 3rd generation partnership project (3GPP) long-term evolution (LTE) is part of E-UMTS using E-UTRA. 3GPP LTE adopts OFDMA on downlink (DL) and adopts SC-FDMA on uplink (UL). LTE-advanced (LTE-A) is an evolved version of 3GPP LTE.

For convenience of description, description will be given under the assumption that the present disclosure is applied to a 3GPP-based communication system, for example, LTE and/or new RAT (NR). However, the technical features of the present disclosure are not limited thereto. For example, although the following detailed description is given based on mobile communication systems corresponding to 3GPP LTE/NR systems, the mobile communication systems are applicable to other arbitrary mobile communication systems except for matters that are specific to the 3GPP LTE/NR system.

For terms and techniques that are not described in detail among terms and techniques used in the present disclosure, reference may be made to 3GPP based standard specifications, for example, 3GPP TS 36.211, 3GPP TS 36.212, 3GPP TS 36.213, 3GPP TS 36.321, 3GPP TS 36.300, 3GPP TS 36.331, 3GPP TS 37.213, 3GPP TS 38.211, 3GPP TS 38.212, 3GPP TS 38.213, 3GPP TS 38.214, 3GPP TS 38.300, 3GPP TS 38.331, etc.

In examples of the present disclosure described later, if a device "assumes" something, this may mean that a channel transmission entity transmits a channel in compliance with the corresponding "assumption." This also may mean that a channel reception entity receives or decodes the channel in the form of conforming to the "assumption" on the premise that the channel has been transmitted in compliance with the "assumption."

In the present disclosure, a user equipment (UE) may be fixed or mobile. Each of various devices that transmit and/or receive user data and/or control information by communicating with a base station (BS) may be the UE. The term UE may be referred to as terminal equipment, mobile station (MS), mobile terminal (MT), user terminal (UT), subscriber station (SS), wireless device, personal digital assistant (PDA), wireless modem, handheld device, etc. In the present disclosure, a BS refers to a fixed station that communicates with a UE and/or another BS and exchanges data and control information with a UE and another BS. The term BS may be referred to as advanced base station (ABS), Node-B (NB), evolved Node-B (eNB), base transceiver system (BTS), access point (AP), processing server (PS), etc. Particularly, a BS of a universal terrestrial radio access (UTRAN) is referred to as an NB, a BS of an evolved-UTRAN (E-UTRAN) is referred to as an eNB, and a BS of new radio access technology network is referred to as a gNB. Hereinbelow, for convenience of description, the NB, eNB, or gNB will be referred to as a BS regardless of the type or version of communication technology.

In the present disclosure, a node refers to a fixed point capable of transmitting/receiving a radio signal to/from a UE by communication with the UE. Various types of BSs may be used as nodes regardless of the names thereof. For example, a BS, NB, eNB, pico-cell eNB (PeNB), home eNB (HeNB), relay, repeater, etc. may be a node. Furthermore, a node may not be a BS. For example, a radio remote head (RRH) or a radio remote unit (RRU) may be a node. Generally, the RRH and RRU have power levels lower than that of the BS. Since the RRH or RRU (hereinafter, RRH/RRU) is connected to the BS through a dedicated line such as an optical cable in general, cooperative communication according to the RRH/RRU and the BS may be smoothly performed relative to cooperative communication according to BSs connected through a wireless link. At least one antenna is installed per node. An antenna may refer to a physical antenna or refer to a virtual antenna or an antenna group. The node may also be called a point.

In the present disclosure, a cell refers to a specific geographical area in which one or more nodes provide communication services. Accordingly, in the present disclosure, communication with a specific cell may mean communication with a BS or a node providing communication services to the specific cell. A DL/UL signal of the specific cell refers to a DL/UL signal from/to the BS or the node providing communication services to the specific cell. A cell providing UL/DL communication services to a UE is especially called a serving cell. Furthermore, channel status/quality of the specific cell refers to channel status/quality of a channel or a communication link generated between the BS or the node providing communication services to the specific cell and the UE. In 3GPP-based communication systems, the UE may measure a DL channel state from a specific node using cell-specific reference signal(s) (CRS(s)) transmitted on a CRS resource and/or channel state information reference signal(s) (CSI-RS(s)) transmitted on a CSI-RS resource, allocated to the specific node by antenna port(s) of the specific node.

A 3GPP-based communication system uses the concept of a cell in order to manage radio resources, and a cell related with the radio resources is distinguished from a cell of a geographic area.

The "cell" of the geographic area may be understood as coverage within which a node may provide services using a carrier, and the "cell" of the radio resources is associated with bandwidth (BW), which is a frequency range configured by the carrier. Since DL coverage, which is a range within which the node is capable of transmitting a valid signal, and UL coverage, which is a range within which the node is capable of receiving the valid signal from the UE, depend upon a carrier carrying the signal, coverage of the node may also be associated with coverage of the "cell" of radio resources used by the node. Accordingly, the term "cell" may be used to indicate service coverage by the node sometimes, radio resources at other times, or a range that a signal using the radio resources may reach with valid strength at other times.

In 3GPP communication standards, the concept of the cell is used in order to manage radio resources. The "cell" associated with the radio resources is defined by a combination of DL resources and UL resources, that is, a combination of a DL component carrier (CC) and a UL CC. The cell may be configured by the DL resources only or by the combination of the DL resources and the UL resources. If carrier aggregation is supported, linkage between a carrier frequency of the DL resources (or DL CC) and a carrier frequency of the UL resources (or UL CC) may be indicated by system information. For example, the combination of the DL resources and the UL resources may be indicated by system information block type 2 (SIB2) linkage. In this case, the carrier frequency may be equal to or different from a center frequency of each cell or CC. When carrier aggregation (CA) is configured, the UE has only one radio resource control (RRC) connection with a network. During RRC connection establishment/re-establishment/handover, one serving cell provides non-access stratum (NAS) mobility information. During RRC connection re-establishment/handover, one serving cell provides security input. This cell is referred to as a primary cell (Pcell). The Pcell refers to a cell operating on a primary frequency on which the UE performs an initial connection establishment procedure or initiates a connection re-establishment procedure. According to UE capability, secondary cells (Scells) may be configured to form a set of serving cells together with the Pcell. The Scell may be configured after completion of RRC connection establishment and used to provide additional radio resources in addition to resources of a specific cell (SpCell). A carrier corresponding to the Pcell on DL is referred to as a downlink primary CC (DL PCC), and a carrier corresponding to the Pcell on UL is referred to as an uplink primary CC (DL PCC). A carrier corresponding to the Scell on DL is referred to as a downlink secondary CC (DL SCC), and a carrier corresponding to the Scell on UL is referred to as an uplink secondary CC (UL SCC).

As more and more communication devices have required greater communication capacity, there has been a need for eMBB communication relative to legacy radio access technology (RAT). In addition, massive MTC for providing various services at anytime and anywhere by connecting a plurality of devices and objects to each other is one main issue to be considered in next-generation communication. Further, communication system design considering services/UEs sensitive to reliability and latency is also under discussion. The introduction of next-generation RAT is being discussed in consideration of eMBB communication, massive MTC, ultra-reliable and low-latency communication (URLLC), and the like. Currently, in 3GPP, a study on the next-generation mobile communication systems after EPC is being conducted. In the present disclosure, for convenience, the corresponding technology is referred to as a new RAT (NR) or fifth-generation (5G) RAT, and a system using NR or supporting NR is referred to as an NR system.

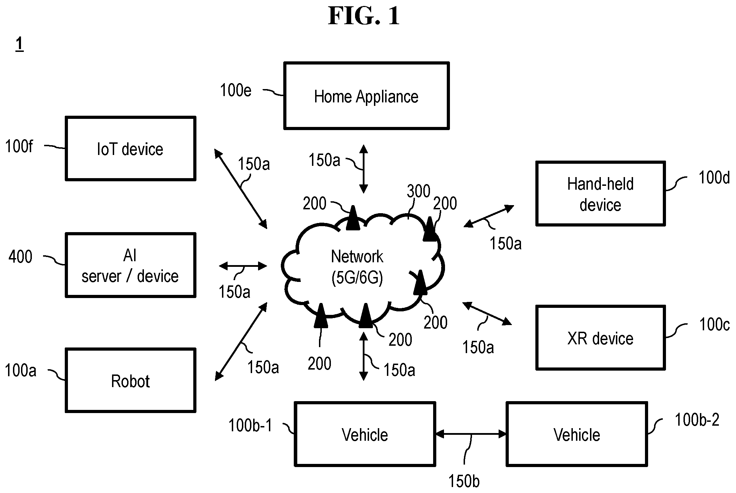

FIG. 1 illustrates an example of a communication system 1 to which implementations of the present disclosure are applied. Referring to FIG. 1, the communication system 1 applied to the present disclosure includes wireless devices, BSs, and a network. Here, the wireless devices represent devices performing communication using RAT (e.g., 5G NR or LTE (e.g., E-UTRA)) and may be referred to as communication/radio/5G devices. The wireless devices may include, without being limited to, a robot 100a, vehicles 100b-1 and 100b-2, an extended reality (XR) device 100c, a hand-held device 100d, a home appliance 100e, an Internet of Things (IoT) device 100f, and an artificial intelligence (AI) device/server 400. For example, the vehicles may include a vehicle having a wireless communication function, an autonomous driving vehicle, and a vehicle capable of performing vehicle-to-vehicle communication. Here, the vehicles may include an unmanned aerial vehicle (UAV) (e.g., a drone). The XR device may include an augmented reality (AR)/virtual reality (VR)/mixed reality (MR) device and may be implemented in the form of a head-mounted device (HMD), a head-up display (HUD) mounted in a vehicle, a television, a smartphone, a computer, a wearable device, a home appliance device, a digital signage, a vehicle, a robot, etc. The hand-held device may include a smartphone, a smartpad, a wearable device (e.g., a smartwatch or smartglasses), and a computer (e.g., a notebook). The home appliance may include a TV, a refrigerator, and a washing machine. The IoT device may include a sensor and a smartmeter. For example, the BSs and the network may also be implemented as wireless devices and a specific wireless device may operate as a BS/network node with respect to another wireless device.

The wireless devices 100a to 100f may be connected to a network 300 via BSs 200. AI technology may be applied to the wireless devices 100a to 100f and the wireless devices 100a to 100f may be connected to the AI server 400 via the network 300. The network 300 may be configured using a 3G network, a 4G (e.g., LTE) network, or a 5G (e.g., NR) network. Although the wireless devices 100a to 100f may communicate with each other through the BSs 200/network 300, the wireless devices 100a to 100f may perform direct communication (e.g., sidelink communication) with each other without passing through the BSs/network. For example, the vehicles 100b-1 and 100b-2 may perform direct communication (e.g., vehicle-to-vehicle (V2V)/Vehicle-to-everything (V2X) communication). The IoT device (e.g., a sensor) may perform direct communication with other IoT devices (e.g., sensors) or other wireless devices 100a to 100f.

Wireless communication/connections 150a and 150b may be established between the wireless devices 100a to 100f and the BSs 200 and between the wireless devices 100a to 100f. Here, the wireless communication/connections such as UL/DL communication 150a and sidelink communication 150b (or, device-to-device (D2D) communication) may be established by various RATs (e.g., 5G NR). The wireless devices and the BSs/wireless devices may transmit/receive radio signals to/from each other through the wireless communication/connections 150a and 150b. To this end, at least a part of various configuration information configuring processes, various signal processing processes (e.g., channel encoding/decoding, modulation/demodulation, and resource mapping/demapping), and resource allocating processes, for transmitting/receiving radio signals, may be performed based on the various proposals of the present disclosure.

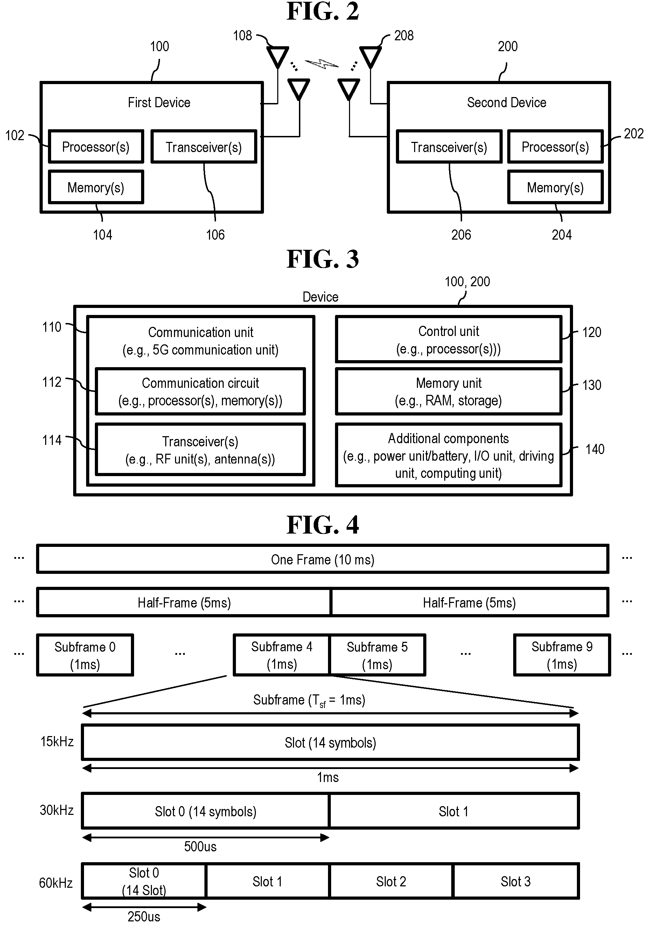

FIG. 2 is a block diagram illustrating examples of communication devices capable of performing a method according to the present disclosure. Referring to FIG. 2, a first wireless device 100 and a second wireless device 200 may transmit and/or receive radio signals through a variety of RATs (e.g., LTE and NR). Here, {the first wireless device 100 and the second wireless device 200} may correspond to {the wireless device 100x and the BS 200} and/or {the wireless device 100x and the wireless device 100x} of FIG. 1.

The first wireless device 100 may include one or more processors 102 and one or more memories 104 and additionally further include one or more transceivers 106 and/or one or more antennas 108. The processor(s) 102 may control the memory(s) 104 and/or the transceiver(s) 106 and may be configured to implement the below-described /proposed functions, procedures, and/or methods. For example, the processor(s) 102 may process information within the memory(s) 104 to generate first information/signals and then transmit radio signals including the first information/signals through the transceiver(s) 106. The processor(s) 102 may receive radio signals including second information/signals through the transceiver(s) 106 and then store information obtained by processing the second information/signals in the memory(s) 104. The memory(s) 104 may be connected to the processor(s) 102 and may store a variety of information related to operations of the processor(s) 102. For example, the memory(s) 104 may perform a part or all of processes controlled by the processor(s) 102 or store software code including instructions for performing the below-described/proposed procedures and/or methods. Here, the processor(s) 102 and the memory(s) 104 may be a part of a communication modem/circuit/chip designed to implement RAT (e.g., LTE or NR). The transceiver(s) 106 may be connected to the processor(s) 102 and transmit and/or receive radio signals through one or more antennas 108. Each of the transceiver(s) 106 may include a transmitter and/or a receiver. The transceiver(s) 106 is used interchangeably with radio frequency (RF) unit(s). In the present disclosure, the wireless device may represent the communication modem/circuit/chip.

The second wireless device 200 may include one or more processors 202 and one or more memories 204 and additionally further include one or more transceivers 206 and/or one or more antennas 208. The processor(s) 202 may control the memory(s) 204 and/or the transceiver(s) 206 and may be configured to implement the below-described/proposed functions, procedures, and/or methods. For example, the processor(s) 202 may process information within the memory(s) 204 to generate third information/signals and then transmit radio signals including the third information/signals through the transceiver(s) 206. The processor(s) 202 may receive radio signals including fourth information/signals through the transceiver(s) 206 and then store information obtained by processing the fourth information/signals in the memory(s) 204. The memory(s) 204 may be connected to the processor(s) 202 and may store a variety of information related to operations of the processor(s) 202. For example, the memory(s) 204 may perform a part or all of processes controlled by the processor(s) 202 or store software code including instructions for performing the below-described/proposed procedures and/or methods. Here, the processor(s) 202 and the memory(s) 204 may be a part of a communication modem/circuit/chip designed to implement RAT (e.g., LTE or NR). The transceiver(s) 206 may be connected to the processor(s) 202 and transmit and/or receive radio signals through one or more antennas 208. Each of the transceiver(s) 206 may include a transmitter and/or a receiver. The transceiver(s) 206 is used interchangeably with RF unit(s). In the present disclosure, the wireless device may represent the communication modem/circuit/chip.

The wireless communication technology implemented in the wireless devices 100 and 200 of the present disclosure may include narrowband Internet of things for low-power communication as well as LTE, NR, and 6G. For example, the NB-IoT technology may be an example of low-power wide-area network (LPWAN) technologies and implemented in standards such as LTE Cat NB1 and/or LTE Cat NB2. However, the NB-IoT technology is not limited to the above names. Additionally or alternatively, the wireless communication technology implemented in the wireless devices XXX and YYY of the present disclosure may perform communication based on the LTE-M technology. For example, the LTE-M technology may be an example of LPWAN technologies and called by various names including enhanced machine type communication (eMTC). For example, the LTE-M technology may be implemented in at least one of the following various standards: 1) LTE CAT 0, 2) LTE Cat M1, 3) LTE Cat M2, 4) LTE non-Bandwidth Limited (non-BL), 5) LTE-MTC, 6) LTE Machine Type Communication, and/or 7) LTE M, etc., but the LTE-M technology is not limited to the above names. Additionally or alternatively, the wireless communication technology implemented in the wireless devices XXX and YYY of the present disclosure may include at least one of ZigBee, Bluetooth, and LPWAN in consideration of low-power communication, but the wireless communication technology is not limited to the above names. For example, the ZigBee technology may create a personal area network (PAN) related to small/low-power digital communication based on various standards such as IEEE 802.15.4 and so on, and the ZigBee technology may be called by various names.

Hereinafter, hardware elements of the wireless devices 100 and 200 will be described more specifically. One or more protocol layers may be implemented by, without being limited to, one or more processors 102 and 202. For example, the one or more processors 102 and 202 may implement one or more layers (e.g., functional layers such as a physical (PHY) layer, medium access control (MAC) layer, a radio link control (RLC) layer, a packet data convergence protocol (PDCP) layer, radio resource control (RRC) layer, and a service data adaptation protocol (SDAP) layer). The one or more processors 102 and 202 may generate one or more protocol data units (PDUs) and/or one or more service data units (SDUs) according to the functions, procedures, proposals, and/or methods disclosed in the present disclosure. The one or more processors 102 and 202 may generate messages, control information, data, or information according to the functions, procedures, proposals, and/or methods disclosed in the present disclosure. The one or more processors 102 and 202 may generate signals (e.g., baseband signals) including PDUs, SDUs, messages, control information, data, or information according to the functions, procedures, proposals, and/or methods disclosed in the present disclosure and provide the generated signals to the one or more transceivers 106 and 206. The one or more processors 102 and 202 may receive the signals (e.g., baseband signals) from the one or more transceivers 106 and 206 and acquire the PDUs, SDUs, messages, control information, data, or information according to the functions, procedures, proposals, and/or methods disclosed in the present disclosure.

The one or more processors 102 and 202 may be referred to as controllers, microcontrollers, microprocessors, or microcomputers. The one or more processors 102 and 202 may be implemented by hardware, firmware, software, or a combination thereof. As an example, one or more application specific integrated circuits (ASICs), one or more digital signal processors (DSPs), one or more digital signal processing devices (DSPDs), one or more programmable logic devices (PLDs), or one or more field programmable gate arrays (FPGAs) may be included in the one or more processors 102 and 202. The functions, procedures, proposals, and/or methods disclosed in the present disclosure may be implemented using firmware or software, and the firmware or software may be configured to include the modules, procedures, or functions. Firmware or software configured to perform the functions, procedures, proposals, and/or methods disclosed in the present disclosure may be included in the one or more processors 102 and 202 or stored in the one or more memories 104 and 204 so as to be driven by the one or more processors 102 and 202. The functions, procedures, proposals, and/or methods disclosed in the present disclosure may be implemented using firmware or software in the form of code, commands, and/or a set of commands.

The one or more memories 104 and 204 may be connected to the one or more processors 102 and 202 and store various types of data, signals, messages, information, programs, code, commands, and/or instructions. The one or more memories 104 and 204 may be configured by read-only memories (ROMs), random access memories (RAMs), electrically erasable programmable read-only memories (EPROMs), flash memories, hard drives, registers, cache memories, computer-readable storage media, and/or combinations thereof. The one or more memories 104 and 204 may be located at the interior and/or exterior of the one or more processors 102 and 202. The one or more memories 104 and 204 may be connected to the one or more processors 102 and 202 through various technologies such as wired or wireless connection.

The one or more transceivers 106 and 206 may transmit user data, control information, and/or radio signals/channels, mentioned in the methods and/or operational flowcharts of the present disclosure, to one or more other devices. The one or more transceivers 106 and 206 may receive user data, control information, and/or radio signals/channels, mentioned in the functions, procedures, proposals, methods, and/or operational flowcharts disclosed in the present disclosure, from one or more other devices. For example, the one or more transceivers 106 and 206 may be connected to the one or more processors 102 and 202 and transmit and receive radio signals. For example, the one or more processors 102 and 202 may perform control so that the one or more transceivers 106 and 206 may transmit user data, control information, or radio signals to one or more other devices. The one or more processors 102 and 202 may perform control so that the one or more transceivers 106 and 206 may receive user data, control information, or radio signals from one or more other devices. The one or more transceivers 106 and 206 may be connected to the one or more antennas 108 and 208. The one or more transceivers 106 and 206 may be configured to transmit and receive user data, control information, and/or radio signals/channels, mentioned in the functions, procedures, proposals, methods, and/or operational flowcharts disclosed in the present disclosure, through the one or more antennas 108 and 208. In the present disclosure, the one or more antennas may be a plurality of physical antennas or a plurality of logical antennas (e.g., antenna ports). The one or more transceivers 106 and 206 may convert received radio signals/channels etc. from RF band signals into baseband signals in order to process received user data, control information, radio signals/channels, etc. using the one or more processors 102 and 202. The one or more transceivers 106 and 206 may convert the user data, control information, radio signals/channels, etc. processed using the one or more processors 102 and 202 from the base band signals into the RF band signals. To this end, the one or more transceivers 106 and 206 may include (analog) oscillators and/or filters.

FIG. 3 illustrates another example of a wireless device capable of performing implementation(s) of the present disclosure. Referring to FIG. 3, wireless devices 100 and 200 may correspond to the wireless devices 100 and 200 of FIG. 2 and may be configured by various elements, components, units/portions, and/or modules. For example, each of the wireless devices 100 and 200 may include a communication unit 110, a control unit 120, a memory unit 130, and additional components 140. The communication unit may include a communication circuit 112 and transceiver(s) 114. For example, the communication circuit 112 may include the one or more processors 102 and 202 and/or the one or more memories 104 and 204 of FIG. 2. For example, the transceiver(s) 114 may include the one or more transceivers 106 and 206 and/or the one or more antennas 108 and 208 of FIG. 2. The control unit 120 is electrically connected to the communication unit 110, the memory 130, and the additional components 140 and controls overall operation of the wireless devices. For example, the control unit 120 may control an electric/mechanical operation of the wireless device based on programs/code/commands/information stored in the memory unit 130. The control unit 120 may transmit the information stored in the memory unit 130 to the exterior (e.g., other communication devices) via the communication unit 110 through a wireless/wired interface or store, in the memory unit 130, information received through the wireless/wired interface from the exterior (e.g., other communication devices) via the communication unit 110.

The additional components 140 may be variously configured according to types of wireless devices. For example, the additional components 140 may include at least one of a power unit/battery, input/output (I/O) unit, a driving unit, and a computing unit. The wireless device may be implemented in the form of, without being limited to, the robot (100a of FIG. 1), the vehicles (100b-1 and 100b-2 of FIG. 1), the XR device (100c of FIG. 1), the hand-held device (100d of FIG. 1), the home appliance (100e of FIG. 1), the IoT device (100f of FIG. 1), a digital broadcast UE, a hologram device, a public safety device, an MTC device, a medical device, a fintech device (or a finance device), a security device, a climate/environment device, the AI server/device (400 of FIG. 1), the BS (200 of FIG. 1), a network node, etc. The wireless device may be used in a mobile or fixed place according to a use-case/service.

In FIG. 3, the entirety of the various elements, components, units/portions, and/or modules in the wireless devices 100 and 200 may be connected to each other through a wired interface or at least a part thereof may be wirelessly connected through the communication unit 110. For example, in each of the wireless devices 100 and 200, the control unit 120 and the communication unit 110 may be connected by wire and the control unit 120 and first units (e.g., 130 and 140) may be wirelessly connected through the communication unit 110. Each element, component, unit/portion, and/or module within the wireless devices 100 and 200 may further include one or more elements. For example, the control unit 120 may be configured by a set of one or more processors. As an example, the control unit 120 may be configured by a set of a communication control processor, an application processor, an electronic control unit (ECU), a graphical processing unit, and a memory control processor. As another example, the memory 130 may be configured by a random access memory (RAM), a dynamic RAM (DRAM), a read-only memory (ROM)), a flash memory, a transitory memory, a non-transitory memory, and/or a combination thereof.

In the present disclosure, the at least one memory (e.g., 104 or 204) may store instructions or programs, and the instructions or programs may cause, when executed, at least one processor operably connected to the at least one memory to perform operations according to some embodiments or implementations of the present disclosure.

In the present disclosure, a computer readable (non-transitory) storage medium may store at least one instruction or program, and the at least one instruction or program may cause, when executed by at least one processor, the at least one processor to perform operations according to some embodiments or implementations of the present disclosure.

In the present disclosure, a processing device or apparatus may include at least one processor, and at least one computer memory operably connected to the at least one processor. The at least one computer memory may store instructions or programs, and the instructions or programs may cause, when executed, the at least one processor operably connected to the at least one memory to perform operations according to some embodiments or implementations of the present disclosure.

In the present disclosure, a computer program may include program code stored on at least one (non-transitory) computer-readable storage medium and, when executed, configured to perform operations according to some implementations of the present disclosure or cause at least one processor to perform the operations according to some implementations of the present disclosure. The computer program may be provided in the form of a computer program product. The computer program product may include at least one (non-transitory) computer-readable storage medium.

A communication device of the present disclosure includes at least one processor; and at least one computer memory operably connected to the at least one processor and configured to store instructions for causing, when executed, the at least one processor to perform operations according to example(s) of the present disclosure described later.

FIG. 4 illustrates an example of a frame structure used in a 3GPP-based wireless communication system.

The frame structure of FIG. 4 is purely exemplary and the number of subframes, the number of slots, and the number of symbols, in a frame, may be variously changed. In an NR system, different OFDM numerologies (e.g., subcarrier spacings (SCSs)) may be configured for multiple cells which are aggregated for one UE. Accordingly, the (absolute time) duration of a time resource including the same number of symbols (e.g., a subframe, a slot, or a transmission time interval (TTI)) may be differently configured for the aggregated cells. Here, the symbol may include an OFDM symbol (or cyclic prefix - OFDM (CP-OFDM) symbol) and an SC-FDMA symbol (or discrete Fourier transform-spread-OFDM (DFT-s-OFDM) symbol). In the present disclosure, the symbol, the OFDM-based symbol, the OFDM symbol, the CP-OFDM symbol, and the DFT-s-OFDM symbol are used interchangeably.

Referring to FIG. 4, in the NR system, UL and DL transmissions are organized into frames. Each frame has a duration of T_{f}=(△fₘₐₓ*N_{f}/100)*T_{c} = 10 ms and is divided into two half-frames of 5 ms each. A basic time unit for NR is T_{c} = 1/(△fₘₐₓ*N_{f}) where △fₘₐₓ = 480*10³ Hz and N_{f}= 4096. For reference, a basic time unit for LTE is Tₛ = 1/(△f_{ref}*N_{f,ref}) where △f_{ref} = 15*10³ Hz and N_{f,ref}= 2048. T_{c} and T_{f} have the relationship of a constant K = T_{c}/T_{f} = 64. Each half-frame includes 5 subframes and a duration T_{sf} of a single subframe is 1 ms. Subframes are further divided into slots and the number of slots in a subframe depends on a subcarrier spacing. Each slot includes 14 or 12 OFDM symbols based on a cyclic prefix. In a normal CP, each slot includes 14 OFDM symbols and, in an extended CP, each slot includes 12 OFDM symbols. The numerology depends on an exponentially scalable subcarrier spacing Δf= 2^{u}*15 kHz. The table below shows the number of OFDM symbols (*N*^{slot}_{symb}) per slot, the number of slots (*N*^{frame,u}ₛₗₒₜ) per frame, and the number of slots (*N*^{subframe,u}ₛₗₒₜ) per subframe.

**Table 1**

| *u* | *N*^{slot}_{symb} | *N*^{frame,u}ₛₗₒₜ | *N*^{subframe,u}ₛₗₒₜ |
|---|---|---|---|
| 0 | 14 | 10 | 1 |
| 1 | 14 | 20 | 2 |
| 2 | 14 | 40 | 4 |
| 3 | 14 | 80 | 8 |
| 4 | 14 | 160 | 16 |

The table below shows the number of OFDM symbols per slot, the number of slots per frame, and the number of slots per subframe, according to the subcarrier spacing △f = 2^{u}*15 kHz.

**Table 2**

| *u* | *N*^{slot}_{symb} | *N*^{frame,u}ₛₗₒₜ | *N*^{subframe,u}ₛₗₒₜ |
|---|---|---|---|
| 2 | 12 | 40 | 4 |

For a subcarrier spacing configuration u, slots may be indexed within a subframe in ascending order as follows: n^{u}ₛ ∈ {0, ..., n^{subframe,u}ₛₗₒₜ - 1} and indexed within a frame in ascending order as follows: n^{u}_{s,f} ∈ {0, ..., n^{frame,u}ₛₗₒₜ - 1}.

The slot includes multiple (e.g., 14 or 12) symbols in the time domain. For each numerology (e.g., subcarrier spacing) and carrier, a resource grid of *N*^{size,u} _{grid,x}**N*^{RB}_{sc} subcarriers and *N*^{subframe,u}_{symb} OFDM symbols is defined, starting at a common resource block (CRB) N^{start,u}_{grid} indicated by higher layer signaling (e.g., RRC signaling), where *N*^{size,u}_{grid,x} is the number of resource blocks (RBs) in the resource grid and the subscript x is DL for downlink and UL for uplink. *N*^{RB}_{sc} is the number of subcarriers per RB. In the 3GPP-based wireless communication system, *N*^{RB}_{sc} is typically 12. There is one resource grid for a given antenna port *p*, a subcarrier spacing configuration *u*, and a transmission link (DL or UL). The carrier bandwidth *N*^{size,u}_{grid} for the subcarrier spacing configuration *u* is given to the UE by a higher layer parameter (e.g., RRC parameter). Each element in the resource grid for the antenna port *p* and the subcarrier spacing configuration *u* is referred to as a resource element (RE) and one complex symbol may be mapped to each RE. Each RE in the resource grid is uniquely identified by an index *k* in the frequency domain and an index *l* representing a symbol location relative to a reference point in the time domain. In the NR system, an RB is defined by 12 consecutive subcarriers in the frequency domain. In the NR system, RBs are classified into CRBs and physical resource blocks (PRBs). The CRBs are numbered from 0 upwards in the frequency domain for the subcarrier spacing configuration *u*. The center of subcarrier 0 of CRB 0 for the subcarrier spacing configuration *u* is equal to 'Point A' which serves as a common reference point for RB grids. The PRBs for subcarrier spacing configuration *u* are defined within a bandwidth part (BWP) and numbered from 0 to *N*^{size,u}_{BWP,i}-1, where i is a number of the BWP. The relation between a PRB n_{PRB} in a BWP i and a CRB n^{u}_{CRB} is given by: n^{u}_{PRB} = n^{u}_{CRB} + *N*^{start,u}_{BWP,i}, where *N*^{start}_{BWP,i} is a CRB in which the BWP starts relative to CRB 0. The BWP includes a plurality of consecutive RBs in the frequency domain. For example, the BWP may be a subset of contiguous CRBs defined for a given numerology uᵢ in the BWP i on a given carrier. A carrier may include a maximum of N (e.g., 5) BWPs. The UE may be configured to have one or more BWPs on a given component carrier. Data communication is performed through an activated BWP and only a predetermined number of BWPs (e.g., one BWP) among BWPs configured for the UE may be active on the component carrier.

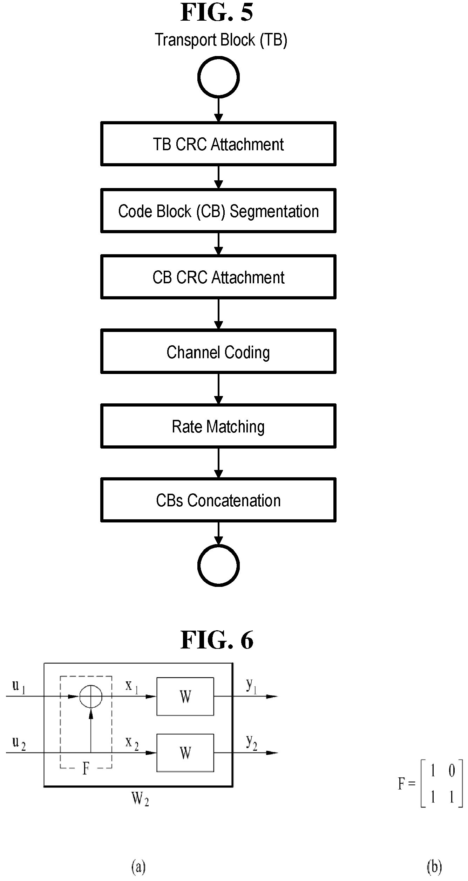

FIG. 5 illustrates a process for processing a transport block (TB) on a transmitting side.

In order for a receiving side to correct errors that radio signals experience in a radio channel, a transmitting side performs conding on information using a forward error correction code and then transmits the coded information. The receiving side demodulates a received signal and decodes the error correction code to thereby recover the information transmitted by the transmitting side. In this decoding procedure, errors in the received signal caused by a radio channel are corrected.

Data arrives at a coding block in the form of a maximum of two transport blocks every transmission time interval (TTI) in each DL/UL cell. The following coding steps may be applied to each transport block of the DL/UL cell:
- cyclic redundancy check (CRC) adding to a transport block;
- code block segmentation and CRC attachment to a code block;
- channel coding;
- rate matching; and
- code block concatenation.

In an actual communication system, a transport block of a predetermined size or larger is divided into a plurality of smaller data blocks and then is encoded, to facilitate actual implementation of encoding. The smaller data blocks are called code blocks. While the code blocks are generally of the same size, one of the code blocks may have a different size due to a limited size of an internal interleaver of a channel encoder. Error correction coding is performed on each code block of a predetermined interleaver size and then interleaving is performed to reduce the impact of burst errors that are generated during transmission over a radio channel. The error-corrected and interleaved code block is transmitted by being mapped to an actual radio resource. The amount of radio resources used for actual transmission is designated. Thus, the encoded code blocks are rate-matched to the amount of the radio resources. In general, rate matching is performed through puncturing or repetition. For example, if the amount of radio resources, i.e., the number of transmission bits capable of being transmitted on the radio resources, is M and if a coded bit sequence, i.e., the number of output bits of the encoder, is N, in which M is different from N, then rate matching is performed to match the length of the coded bit sequence to M. If M>N, then all or a part of bits of the coded bit sequence are repeated to match the length of the rate-matched sequence to M. If M<N, then a part of the bits of the coded bit sequence is punctured to match the length of the rate-matched sequence to M and the punctured bits are excluded from transmission.

In wireless communication systems, the transmitting side encodes data to be transmitted based on channel coding with a specific code rate. Then, the transmitting side adjusts the code rate of the data to be transmitted through a rate matching process involving puncturing and repetition.

There are various types of error correction codes, but the size of an information block capable of achieving optimal performance is determined depending on the error correction code. While many coding schemes are available for achieving high-capacity information performance with long information block lengths, the majority of the coding schemes do not consistently show good performance over a wide range of information block lengths and code rates. However, turbo codes, low-density parity check (LPDC) codes, and polar codes show promising BLER performance in a wide range of coding rates and code lengths and hence are considered to be used in the NR system. As demand for various cases such as eMBB, massive IoT, and URLLC has increased, a coding scheme providing greater channel coding efficiency than in turbo codes is needed. In addition, increase in a maximum number of subscribers capable of being accommodated by a channel, i.e., increase in capacity, has been required. Polar codes among various error correction codes are codes providing a new framework capable of solving problems of legacy channel codes and were invented by Arikan at Bilkent University (reference: E. Arikan, "Channel Polarization: A Method for Constructing Capacity-Achieving Codes for Symmetric Binary-Input Memoryless Channels," in IEEE Transactions on Information Theory, vol. 55, no. 7, pp. 3051-3073, July 2009). Polar codes are the first capacity-achieving codes with low encoding and decoding complexities, which were proven mathematically. polar codes outperform the turbo codes in large information block lengths while no error flow is present. Hereinafter, channel coding using polar codes is referred to as polar coding.

polar codes are known as codes capable of achieving the channel capacity of a given binary discrete memoryless channel. This can be achieved only when a block size is sufficiently large. That is, polar codes are codes capable of achieving the capacity of a channel if the size N of the codes infinitely increases. polar codes have low encoding and decoding complexity and may be successfully decoded. polar codes are a type of linear block error correction codes. Multiple recursive concatenations are basic building blocks for the polar codes and are bases for code construction. Physical conversion of channels in which physical channels are converted into virtual channels occurs and such conversion is based on a plurality of recursive concatenations. If multiple channels are multiplied and accumulated, most of the channels may become better or worse. The idea underlying polar codes is to use good channels. For example, data is sent through good channels at rate 1 and data is sent through bad channels at rate 0. That is, through channel polarization, channels enter a polarized state from a normal state.

FIG. 6 is an example of a block diagram for a polar encoder.

FIG. 6(a) illustrates a base module of a polar code, particularly, the first level channel combining for polar coding. In FIG. 6(a), **W**₂ denotes an entire equivalent channel obtained by combining two binary-input discrete memoryless channels (B-DMCs), **W**. Herein, u₁ and u₂ are binary-input source bits and y₁ and y₂ are output coded bits. Channel combining is a procedure of concatenating the B-DMCs in parallel.

FIG. 6(b) illustrates a base matrix **F** for the base module. The binary-input source bits u₁ and u₂ input to the base matrix **F** and the corresponding outputs x₁ and x₂ of the base matrix **F** have the following relationship. $\left[{u}_{1} {u}_{2}\right] \left[\begin{matrix}1 & 0 \\ 1 & 1\end{matrix}\right] = \left[{x}_{1} {x}_{2}\right]$ Equation 1

The channel **W**₂ may achieve the symmetric capacity I(**W**), which is the highest rate. In the B-DMC **W**, symmetric capacity is an important parameter which is used to measure a rate and is the highest rate at which reliable communication can occur over the channel **W**. The B-DMC may be defined as follows. $I \left(W\right) = {\sum }_{y ∈ Y} {\sum }_{x ∈ X} \frac{1}{2} W \left(y\left|x\right.\right) log \frac{w \left(y\left|x\right.\right)}{\frac{1}{2} w \left(y\left|0\right.\right) + \frac{1}{2} w \left(y\left|1\right.\right)}$ Equation 2

It is possible to synthesize or create a second set of N binary input channels out of N independent copies of a given B-DMC **W** and the channels have the properties {**W**_{N}⁽ⁱ⁾: 1<=i<=N}. If N increases, there is a tendency for a part of the channels to have a capacity close to 1 and for the remaining channels to have a capacity close to 0. This is called channel polarization. In other words, channel polarization is a process of creating a second set of N channels {**W**_{N}⁽ⁱ⁾: 1<=i<=N} using N independent copies of a given B-DMC **W**. The channel polarization effect means that, when N increases, all symmetric capacity terms {I(**W**_{N}⁽ⁱ⁾)} tend towards 0 or 1 for all except a vanishing fraction of indices i. In other words, the concept behind channel polarization in the polar codes is transforming N copies (i.e., N transmissions) of a channel having a symmetric capacity of I(**W**) (e.g., additive white Gaussian noise channel) into extreme channels of capacity close to 1 or 0. Among the N channels, an I(**W**) fraction will be perfect channels and an 1-I(**W**) fraction will be completely noise channels. Then, information bits are transmitted only through good channels and bits input to the other channels are frozen to 1 or 0. The amount of channel polarization increases along with a block length. Channel polarization consists of two phases: channel combining phase and channel splitting phase.

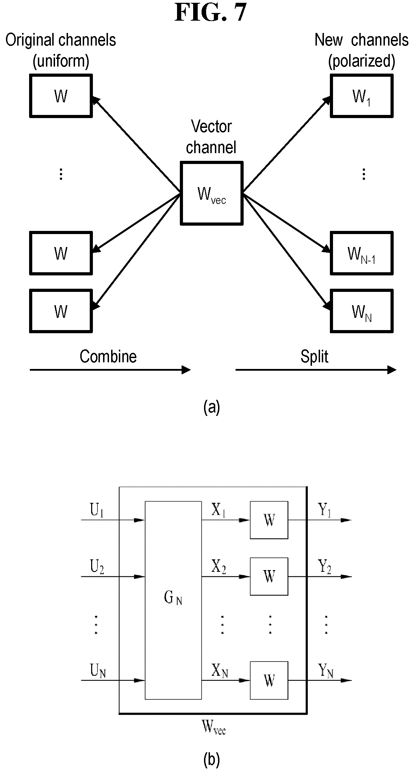

FIG. 7 illustrates the concept of channel combining and channel splitting for channel polarization. As illustrated in FIG. 7, when N copies of an original channel **W** are properly combined to create a vector channel **W**_{vec} and then are split into new polarized channels, the new polarized channels are categorized into channels having capacity C(**W**)=1 and channels having C(**W**)=0 if N is sufficiently large. In this case, since bits passing through the channels having the channel capacity C(**W**)=1 are transmitted without error, it is better to transmit information bits through C(**W**)=1 and, since bits passing through the channels having capacity C(**W**)=0 cannot transport information, it is better to transport frozen bits, which are meaningless bits, therethrough.

Referring to FIG. 7(a), copies of a given B-DMC **W** are combined in a recursive manner to output a vector channel **W**_{vec} given by **W**_{N}: X_{N}→Y_{N}, where N=2ⁿ and n is an integer equal to or greater than 0. Recursion always begins at the 0th level and **W**₁ = **W**. If n is 1 (n=1), this means the first level of recursion in which two independent copies of **W**₁ are combined. If the above two copies are combined, a channel **W**₂: X₂→Y₂ is obtained. A transitional probability of this new channel **W**₂ may be represented by the following equation. ${W}_{2} \left({y}_{1},{y}_{2}\left|{u}_{1}, {u}_{2}\right.\right) = W \left({y}_{1}\left|{u}_{1}⊕{u}_{2}\right.\right) W \left({y}_{1}\left|{u}_{2}\right.\right)$ Equation 3

If the channel **W**₂ is obtained, two copies of the channel **W**₂ are combined to obtain a single copy of a channel **W**₄. Such recursion may be represented by **W**₄: X₄→Y₄ having the following transitional probability. ${W}_{4} \left({y}_{1}^{4}\left|{u}_{1}^{4}\right.\right) = {W}_{2} \left({y}_{1}^{2}\left|{u}_{1}⊕{u}_{2},{u}_{3}⊕{u}_{4}\right.\right) {W}_{2} \left({y}_{3}^{4}\left|{u}_{2}, {u}_{4}\right.\right)$ Equation 4

In FIG. 7(b), **G**_{N} is a size-N generator matrix. The relationship between input **u**^{N}₁ to **G**_{N} and output **x**^{N}₁ of **G**_{N} of FIG. 7(b) may be represented as **x**^{N}₁ = **u**^{N}₁G_{N}, where **x**^{N}₁ = {x₁, ..., x_{N}}, **u**^{N}₁ = {u₁, ..., u_{N}}. When N B-DMCs are combined, each B-DMC may be expressed in a recursive manner. That is, **G**_{N} may be indicated by the following equation. ${G}_{N} = {B}_{N} {F}^{W n}$ Equation 5

Herein, ⓧ denotes the Kronecker product, N=2ⁿ, n>=1, **F**^{ⓧn} = **F**ⓧ**F**^{ⓧ(n-1)}, and **F**^{ⓧ0} = 1. B_{N} is a permutation matrix known as a bit-reversal operation and **B**_{N} = **R**_{N}(**I**₂ⓧ**B**_{N/2}) and may be recursively computed. **I**₂ is a 2-dimensional identity matrix and this recursion is initialized to **B**₂=**I**₂. **R**_{N} is a bit-reversal interleaver and is used to map an input **s**^{N}₁ = {s₁, ..., s_{N}} to an output **x**^{N}₁ = {s₁, s₃,..., s_{N-1}, s₂, ..., s_{N}}. For example, **G**₂ corresponds to a base matrix **F** shown in FIG. 6(b). **G**₄ may be expressed as the following matrix. ${G}_{4} = \left[\begin{matrix}1 & 0 & 0 & 0 \\ 0 & 0 & 1 & 0 \\ 0 & 1 & 0 & 0 \\ 0 & 0 & 0 & 1\end{matrix}\right] {\left[\begin{matrix}1 & 0 \\ 1 & 1\end{matrix}\right]}^{⊗ 2} = \left[\begin{matrix}1 & 0 & 0 & 0 \\ 1 & 0 & 1 & 0 \\ 1 & 1 & 0 & 0 \\ 1 & 1 & 1 & 1\end{matrix}\right]$ Equation 6

A bit-reversal interleaver may not be included on the transmitting side. Without considering the bit-reversal interleaver, **G**_{N} may be expressed as **G**_{N} = (**G**₂)^{ⓧn} (where N=2ⁿ). (**G**₂)^{ⓧn} denotes the n-th Kronecker power of the matrix **G**₂, where **G**₂ is the same as the basic matrix **F** shown in FIG. 6(b).

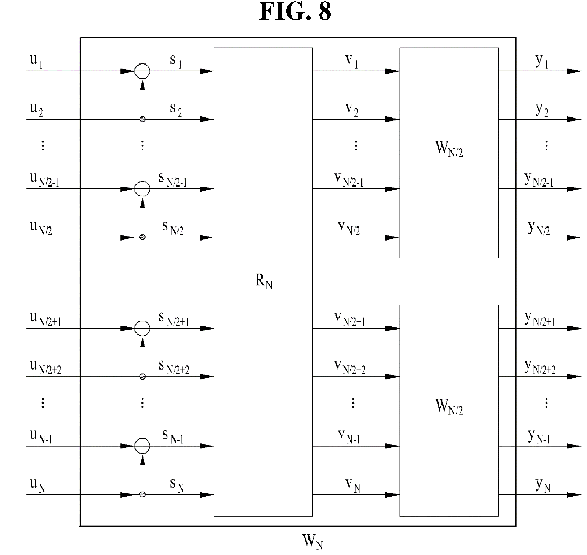

The relationship of Equation 5 is illustrated in FIG. 8.

FIG. 8 illustrates N-th level channel combining for a polar code.

A process of defining an equivalent channel for specific input after combining N B-DMCs **W** is called channel splitting. Channel splitting may be represented as a channel transition probability indicated by the following equation. ${W}_{N}^{i} \left({y}_{1}^{N},{u}_{1}^{i - 1}\left|{u}_{i}\right.\right) = {\sum }_{{u}_{i + 1}^{N}} \frac{1}{{2}^{N - 1}} {W}_{N} \left({y}_{1}^{N}\left|{u}_{1}^{N}\right.\right)$ Equation 7

Channel polarization has the following characteristics:
> $Conservation : C \left({W}^{-}\right) + C \left({W}^{+}\right) = 2 C \left(W\right) ,$
> $C \left({W}^{-}\right) < = C \left(W\right) < = C \left({W}^{+}\right) .$

When channel combining and channel splitting are performed, the following theorem may be obtained.

* Theorem: For any B-DMC **W**, channels {**W**_{N}⁽ⁱ⁾} are polarized in the following sense. For any fixed δ∈{0,1}, as N goes to infinity through powers of 2, the fraction of indices i∈{1,...,N} for channel capacity I(**W**_{N}⁽ⁱ⁾)∈(1-δ,1] goes to I(**W**) and the fraction of indices i for channel capacity I(**W**_{N}⁽ⁱ⁾)∈[0,δ) goes to 1-I(**W**). Hence, if N→∞, then channels are perfectly noisy or are polarized free of noise. These channels can be accurately recognized by the transmitting side. Therefore, bad channels are fixed and non-fixed bits may be transmitted on good channels.

That is, if the size N of polar codes is infinite, a channel has much noise or is free of noise, with respect to a specific input bit. This has the same meaning that the capacity of an equivalent channel for a specific input bit is divided into 0 or I(**W**).

Inputs of a polar encoder are divided into bit channels to which information data is mapped and bit channels to which the information data is not mapped. As described earlier, according to the theory of polar codes, if a codeword of the polar code goes to infinity, the input bit channels may be classified into noiseless channels and noise channels. Therefore, if information is allocated to the noiseless bit channels, channel capacity may be obtained. However, in actuality, a codeword of an infinite length cannot be configured, reliability of the input bit channels is calculated and data bits are allocated to the input bit channels in order of reliability. In the present disclosure, bit channels to which data bits are allocated are referred to as good bit channels. The good bit channels may be input bit channels to which the data bits are mapped. Bit channels to which data is not mapped are referred to as frozen bit channels. A known value (e.g., 0) is input to the frozen bit channels and then encoding is performed. Any values which are known to the transmitting side and the receiving side may be mapped to the frozen bit channels. When puncturing or repetition is performed, information about the good bit channels may be used. For example, positions of codeword bits (i.e., output bits) corresponding to positions of input bits to which information bits are not allocated may be punctured.

A decoding scheme of the polar codes is a successive cancellation (SC) decoding scheme. The SC decoding scheme obtains a channel transition probability and then calculates a likelihood ratio (LLR) of input bits using the channel transition probability. In this case, the channel transition probability may be calculated in a recursive form if channel combining and channel splitting procedures use characteristics of the recursive form. Therefore, a final LLR value may also be calculated in the recursive form. First, a channel transition probability **W**_{N}⁽ⁱ⁾(y₁^{N},u₁ⁱ⁻¹|u₁) of an input bit uᵢ may be obtained as follows. u₁ⁱ may be split into odd indices and even indices, expressed as u_{1,o}ⁱ and u_{1,e}ⁱ, respectively. The channel transition probability may be indicated by the following equations. $\begin{matrix}{W}_{2 N}^{\left(2i-1\right)} \left({y}_{1}^{2 N},{u}_{1}^{2 i - 1}\left|{u}_{2 i - 1}\right.\right) \\ = {\sum }_{{u}_{2 i}^{2 N}} \frac{1}{{2}^{2 N - 1}} {W}_{2 N} \left({y}_{1}^{2 N}\left|{u}_{1}^{2 N}\right.\right) \\ = {\sum }_{{u}_{2 i , o}^{2 N} , {u}_{2 i , e}^{2 N}} \frac{1}{{2}^{2 N - 1}} {W}_{N} \left({y}_{1}^{N}\left|{u}_{1 , o}^{2 N}⊕{u}_{i , e}^{2 N}\right.\right) {W}_{N} \left({y}_{N + 1}^{2 N}\left|{u}_{1 , e}^{2 N}\right.\right) \\ = {\sum }_{{u}_{2 i}} \frac{1}{2} {\sum }_{{u}_{2 i + 1 , e}^{2 N}} \frac{1}{{2}^{N - 1}} {W}_{N} \left({y}_{N + 1}^{2 N}\left|{u}_{1 , e}^{2 N}\right.\right) ⋅ {\sum }_{{u}_{2 i + 1 , o}^{2 N}} \frac{1}{{2}^{N - 1}} {W}_{N} \left({y}_{1}^{N}\left|{u}_{1 , o}^{2 N}⊕{u}_{i , e}^{2 N}\right.\right) \\ = {\sum }_{{u}_{2 i}} \frac{1}{2} {W}_{N}^{\left(i\right)} \left({y}_{1}^{N},{u}_{1 , o}^{2 i - 2}⊕{u}_{i , e}^{2 i - 2}\left|{u}_{2 i - 1}⊕{u}_{2 i}\right.\right) ⋅ {W}_{N}^{\left(i\right)} \left({y}_{N + 1}^{2 N},{u}_{1 , e}^{2 i - 2}\left|{u}_{2 i}\right.\right) \\ where {W}_{N}^{\left(i\right)} \left({y}_{1}^{N},{u}_{1}^{i - 1}\left|{u}_{i}\right.\right) = {\sum }_{{u}_{i + 1}^{N}} \frac{1}{{2}^{N - 1}} {W}_{N} \left({y}_{1}^{N}\left|{u}_{1}^{N}\right.\right) .\end{matrix}$ Equation 8 $\begin{matrix}{W}_{2 N}^{\left(2i\right)} \left({y}_{1}^{2 N},{u}_{1}^{2 i - 1}\left|{u}_{2 i}\right.\right) \\ = {\sum }_{{u}_{2 i + 1}^{2 N}} \frac{1}{{2}^{2 N - 1}} {W}_{2 N} \left({y}_{1}^{2 N}\left|{u}_{1}^{2 N}\right.\right) \\ = {\sum }_{{u}_{2 i + 1 , o}^{2 N} , {u}_{2 i + 1 , e}^{2 N}} \frac{1}{{2}^{2 N - 1}} {W}_{N} \left({y}_{1}^{N}\left|{u}_{1 , o}^{2 N}⊕{u}_{i , e}^{2 N}\right.\right) {W}_{N} \left({y}_{N + 1}^{2 N}\left|{u}_{1 , e}^{2 N}\right.\right) \\ = \frac{1}{2} {\sum }_{{u}_{2 i + 1 , e}^{2 N}} \frac{1}{{2}^{N - 1}} {W}_{N} \left({y}_{N + 1}^{2 N}\left|{u}_{1 , e}^{2 N}\right.\right) ⋅ {\sum }_{{u}_{2 i + 1 , o}^{2 N}} \frac{1}{{2}^{N - 1}} {W}_{N} \left({y}_{1}^{N}\left|{u}_{1 , o}^{2 N}⊕{u}_{i , e}^{2 N}\right.\right) \\ = \frac{1}{2} {W}_{N}^{\left(i\right)} \left({y}_{1}^{N},{u}_{1 , o}^{2 i - 2}⊕{u}_{i , e}^{2 i - 2}\left|{u}_{2 i - 1}⊕{u}_{2 i}\right.\right) ⋅ {W}_{N}^{\left(i\right)} \left({y}_{N + 1}^{2 N},{u}_{1 , e}^{2 i - 2}\left|{u}_{2 i}\right.\right)\end{matrix}$ Equation 9

A polar decoder retrieves information and generates an estimate u^^{N}₁ of u^{N}₁ using values (e.g., reception bits, frozen bits, etc.) known for the polar codes. The LLR is defined as follows. ${L}_{N}^{\left(i\right)} \left({y}_{1}^{N}, {u}_{1}^{i - 1}\right) = \frac{{W}_{N}^{\left(i\right)} \left({y}_{1}^{N},{u}_{1}^{i - 1}\left|{u}_{i}=0\right.\right)}{{W}_{N}^{\left(i\right)} \left({y}_{1}^{N},{u}_{1}^{i - 1}\left|{u}_{i}=1\right.\right)}$ Equation 10

The LLR may be recursively calculated as follows. $\begin{matrix}{L}_{N}^{\left(2i-1\right)} \left({y}_{1}^{N}, {\hat{u}}_{1}^{2 i - 2}\right) = \frac{{L}_{N / 2}^{\left(i\right)} \left({y}_{1}^{N / 2},{\hat{u}}_{1 , o}^{2 i - 2}⊕{\hat{u}}_{1 , e}^{2 i - 2}\right) ⋅ {L}_{N / 2}^{\left(i\right)} \left({y}_{N / 2 + 1}^{N}, {\hat{u}}_{1 , e}^{2 i - 2}\right) + 1}{{L}_{N / 2}^{\left(i\right)} \left({y}_{1}^{N / 2},{\hat{u}}_{1 , o}^{2 i - 2}⊕{\hat{u}}_{1 , e}^{2 i - 2}\right) + {L}_{N / 2}^{\left(i\right)} \left({y}_{N / 2 + 1}^{N}, {\hat{u}}_{1 , e}^{2 i - 2}\right)} \\ {L}_{N}^{\left(2i\right)} \left({y}_{1}^{N}, {\hat{u}}_{1}^{2 i - 1}\right) = {\left[{L}_{N / 2}^{\left(i\right)}\left({y}_{1}^{N / 2},{\hat{u}}_{1 , o}^{2 i - 2}⊕{\hat{u}}_{1 , e}^{2 i - 2}\right)\right]}^{1 - 2 {\hat{u}}_{2 i - 1}} ⋅ {L}_{N / 2}^{\left(i\right)} \left({y}_{N / 2 + 1}^{N}, {\hat{u}}_{1 , e}^{2 i - 2}\right)\end{matrix}$ Equation 11

Recursive calculation of LLRs is traced back to a code length of 1 with an LLR L⁽¹⁾₁(yᵢ) = W(yᵢ|0)/W(yᵢ|1). L⁽¹⁾₁(yᵢ) is soft information observed from a channel.

The complexity of a polar encoder and an SC decoder varies with the length N of polar codes and is known as having *O(NlogN).* Assuming that K input bits are used for a length-N polar code, a coding rate becomes N/K. If a generator matrix of a polar encoder of a data payload size N is **G**_{N}, an encoded bit may be represented as **x**^{N}₁ = **u**^{N}₁**G**_{N}. It is assumed that K bits out of **u**^{N}₁ correspond to payload bits, the row index of **G**_{N} corresponding to the payload bits is i, and a row index of **G**_{N} corresponding to (N-K) bits is F. A minimum distance of the polar codes may be given as dₘᵢₙ(C) = min_{i∈I}2^{wt(i)}, where wt(i) is the number of 1s within binary extension of i and i=0,1,...,N-1.

SC list (SCL) decoding is an extension of a basic SC decoder. In this type of decoder, L decoding paths are simultaneously considered in each decoding stage. Herein, L is an integer. In other words, in the case of the polar codes, a list-L decoding algorithm is an algorithm for simultaneously tracking L paths in a decoding process.

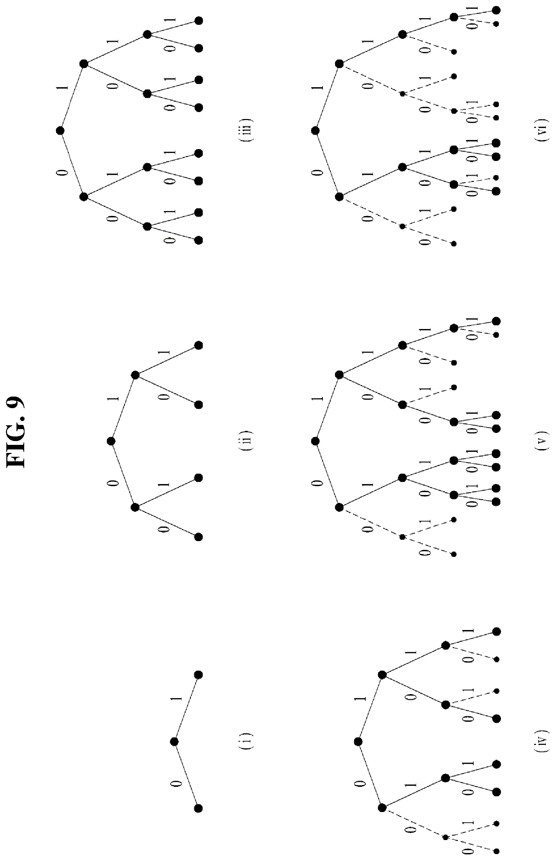

FIG. 9 illustrates an evolution of decoding paths in a list-L decoding process. For convenience of description, it is assumed that the number of bits that should be determined is n and all bits are not frozen. If a list size L is 4, each level includes at most 4 nodes with paths that continue downward. Discontinued paths are expressed by dotted lines in FIG. 9. A process in which decoding paths evolve in list-L decoding will now be described with reference to FIG. 9. i) If list-L decoding is started, the first unfrozen bit may be either 0 or 1. ii) list-L decoding continues. The second unfrozen bits may be either 0 or 1. Since the number of paths is not greater than L=4, pruning is not needed yet. iii) Consideration of all options for the first bit (i.e., a bit of the first level), the second bit (i.e., a bit of the second level), and the third bit (i.e., a bit of the third level) results in 8 decoding paths which are excessive because L=4. iv) the 8 decoding paths are pruned to L (=4) promising paths. v) 4 active paths continue by considering two options of the fourth unfrozen bit. In this case, the number of paths is doubled, i.e., 8 paths which are excessive because L=4. vi) The 8 paths are pruned back to L (=4) best paths. In the example of FIG. 9, 4 candidate codewords 0100, 0110, 0111, and 1111 are obtained and one of the codewords is determined to be a codeword most similar to an original codeword. In a similar manner to a normal decoding process, for example, in a pruning process or a process of determining a final codeword, a path in which the sum of LLR absolute values is largest may be selected as a survival path. If a CRC is present, the survival path may be selected through the CRC.

Meanwhile, CRC-aided SCL decoding is SCL decoding using CRC and improves the performance of polar codes. CRC is the most widely used technique in error detection and error correction in the field of information theory and coding. For example, if an input block of an error correction encoder has K bits and the length of information bits is k, and the length of CRC sequences is m bits, then K = k + m. CRC bits are a part of source bits for an error correction code. If the size of channel codes used for encoding is N, a code rate R is defined as R=K/N. CRC aided SCL decoding serves to detect an errorless path while a receiving device confirms a CRC code with respect to each path. An SCL decoder outputs candidate sequences to a CRC detector. The CRC detector feeds back a check result in order to aid in determining a codeword.

Although complicated as compared with an SC algorithm, SCL decoding or CRC aided SCL decoding has an advantage of excellent decoding performance. For more details of a list-L decoding algorithm of the polar codes, refer to 'I. Tal and A. Vardy, "List decoding of polar codes," in Proc. IEEE Int. Symp. Inf. Theory, pp. 1-5, Jul. 2011'.

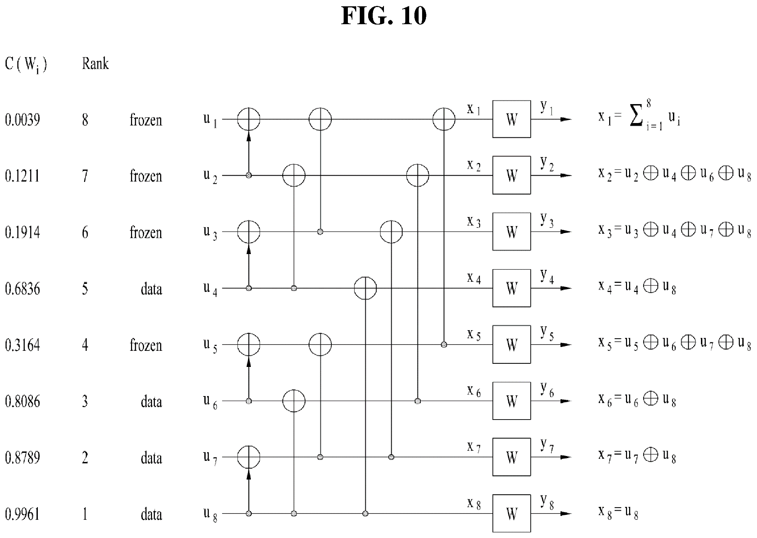

FIG. 10 illustrates the concept of selecting position(s) to which information bit(s) are to be allocated in polar codes.

In the example of FIG. 10, it is assumed that the size N of mother codes is 8, i.e., the size N of polar codes is 8, and a code rate is 1/2.

In FIG. 10, C(**W**ᵢ) denotes the capacity of a channel **W**ᵢ and corresponds to the reliability of channels that input bits of a polar code experience. When channel capacities corresponding to input bit positions of the polar code are as illustrated in FIG. 10, reliability of the input bit positions are ranked as illustrated in FIG. 10. To transmit data at a code rate of 1/2, a transmitting device allocates 4 bits constituting the data to 4 input bit positions having high channel capacities among 8 input bit positions (i.e., input bit positions denoted as u₄, u₆, u₇, and u₈ among input bit positions u₁ to u₈ of FIG. 10) and freezes the other input bit positions. A generator matrix **G**₈ corresponding to the polar code of FIG. 10 is as follows. The generator matrix **G**₈ may be acquired based on (**G**₂)^{ⓧn}. ${G}_{8} = \left[\begin{matrix}1 & 0 & 0 & 0 & 0 & 0 & 0 & 0 \\ 1 & 1 & 0 & 0 & 0 & 0 & 0 & 0 \\ 1 & 0 & 1 & 0 & 0 & 0 & 0 & 0 \\ 1 & 1 & 1 & 1 & 0 & 0 & 0 & 0 \\ 1 & 0 & 0 & 0 & 1 & 0 & 0 & 0 \\ 1 & 1 & 0 & 0 & 1 & 1 & 0 & 0 \\ 1 & 0 & 1 & 0 & 1 & 0 & 1 & 0 \\ 1 & 1 & 1 & 1 & 1 & 1 & 1 & 1\end{matrix}\right]$ Equation 12

The input bit positions denoted as u₁ to u₈ of FIG. 10 correspond one by one to rows from the highest row to the lowest row of **G**₈. Referring to FIG. 10, it may be appreciated that the input bit corresponding to u₈ affects all output coded bits. On the other hand, it may be appreciated that the input bit corresponding to u₁ affects only y₁ among the output coded bits. Referring to Equation 12, when binary-input source bits u₁ to u₈ are multiplied by **G**₈, a row in which the input bits appear at all output bits is the lowest row [1, 1, 1, 1, 1, 1, 1, 1] in which all elements are 1, among rows of **G**₈. Meanwhile, a row in which the binary-input source bit appears at only one output bit is a row in which one element is 1 among the rows of **G**₈, i.e., a row [1, 0, 0, 0, 0, 0, 0, 0] in which a row weight is 1. Similarly, it may be appreciated that a row in which a row weight is 2 reflects input bits corresponding to the row in two output bits. Referring to FIG. 10 and Equation 12, u₁ to u₈ correspond one by one to the rows of **G**₈ and bit indices for distinguishing between input positions of u₁ to u₈, i.e., bit indices for distinguishing between the input positions, may be assigned to the rows of **G**₈.

Hereinafter, for polar codes, it may be assumed that bit indices from 0 to N-1 are sequentially allocated to rows of **G**_{N} starting from the highest row having the smallest row weight with respect to N input bits. For example, referring to FIG. 10, a bit index 0 is allocated to the input position of u₁, i.e., the first row of **G**₈ and a bit index 7 is allocated to the input position of u₈, i.e., the last row of **G**₈. However, since the bit indices are used to indicate input positions of the polar code, a scheme different from the above allocation scheme may be used. For example, bit indices from 0 to N-1 may be allocated starting from the lowest row having the largest row weight.

In the case of output bit indices, as illustrated in FIG. 10 and Equation 12, it may be assumed that bit indices from 0 to N-1 or bit indices from 1 to N are assigned to columns from the first column having the largest column weight to the last column having the smallest column weight among columns of **G**_{N}.

In polar codes, setting of information bits and frozen bits is one of the most important elements in the configuration and performance of the polar code. That is, determination of ranks of input bit positions may be an important element in the performance and configuration of the polar code. For polar codes, bit indices may distinguish input or output positions of the polar code. In the present disclosure, a sequence obtained by enumerating reliability of bit positions in ascending or descending order is referred to as a bit indices sequence or polar sequence. That is, the bit indices sequence represents reliability of input or output bit positions of the polar code in ascending or descending order. A transmitting device inputs information bits to input bits having high reliability based on the input bit indices sequence and performs encoding using the polar code. A receiving device may discern input positions to which information bits are allocated or input positions to which frozen bits are allocated, using the same or corresponding input bit indices sequence. That is, the receiving device may perform polar decoding using an input bit indices sequence which is identical to or corresponds to an input bit indices sequence used by the transmitting device and using a corresponding polar code. In the following description, it may be assumed that an input bit indices sequence is predetermined so that information bit(s) may be allocated to input bit position(s) having high reliability. In the present disclosure, the input bit indices sequence is also called a Polar sequence.

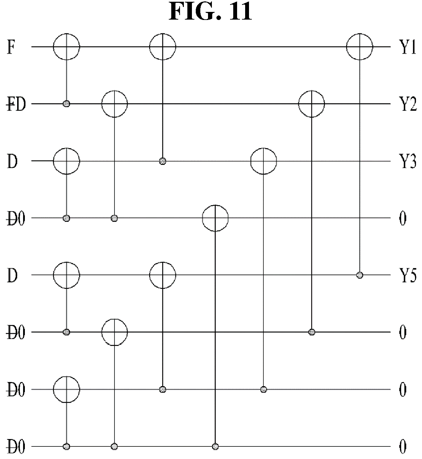

FIG. 11 illustrates puncturing and information bit allocation for polar codes. In FIG. 11, F denotes a frozen bit, D denotes an information bit, and 0 denotes a skipping bit.

Among coded bits, the case in which an information bit is changed to a frozen bit may occur according to an index or position of a punctured bit. For example, if output coded bits for a mother code of N=8 should be punctured in order of Y8, Y7, Y6, Y4, Y5, Y3, Y2, and Y1 and a target code rate is 1/2, then Y8, Y7, Y6, and Y4 are punctured, U8, U7, U6, and U4 connected only to Y8, Y7, Y6, and Y4 are frozen to 0, and these input bits are not transmitted, as illustrated in FIG. 9. An input bit changed to a frozen bit by puncturing of a coded bit is referred to as a skipping bit or a shortening bit and a corresponding input position is referred to as a skipping position or a shortening position. Shortening is a rate matching method of inserting a known bit into an input bit position connected to a position of an output bit desired to be transmitted while maintaining the size of input information (i.e., the size of information blocks). Shortening is possible starting from input corresponding to a column in which a column weight is 1 in a generator matrix **G**_{N} and next shortening may be performed with respect to input corresponding to a column in which a column weight is 1 in a remaining matrix from which a column and row in which a column weight is 1 are removed. To prevent all information bits from being punctured, an information bit that should have been allocated to an information bit position may be reallocated in order of high reliability within a set of frozen bit positions.

In the case of the polar code, decoding may be generally performed in the following order.
> 1. Bit(s) having low reliability are recovered first. Although reliability differs according to the structure of a decoder, since an input index in an encoder (hereinafter, an encoder input bit index or bit index) having a low value usually has a low reliability, decoding is generally performed starting from a low encoder input bit index.
> 2. When there is a known bit for a recovered bit, the known bit is used together with the recovered bit or the process of 1 is omitted and a known bit for a specific input bit position is immediately used, thereby recovering an information bit, which is an unknown bit. The information bit may be a source information bit (e.g., a bit of a transport block) or a CRC bit.

As explained earlier, the process of channel combining and channel splitting results in an equivalent channel being divided into a noisy channel and a noise-free channel. A data payload needs be transmitted over the noise-free channel. In other words, the data payload needs to be transmitted over the noise-free equivalent channel to achieve the desired performance. The noise-free equivalent channel may be determined by computing the value of the equivalent channel, $Z \left(W\right) = \sum \sqrt{W \left(\left.y\right|0\right) W \left(\left.y\right|1\right)}$ for each input bit. Z(W) is called the Battacharyya parameter, which may represent a value corresponding to the upper bound of the error probability when a MAP (maximum a posteriori probability) decision for transmission of binary input 0 or 1 is performed. Therefore, the transmitting side may obtain the values of Z(W), select equivalent channel(s) up to the size of the data payload in ascending order (e.g., increasing order) of the values of Z(W), and use the equivalent channel(s) for transmission of the data payload. For a binary erasure channel (BEC), Z(W) may be obtained through Equation 13. $Z \left({W}_{N}^{\left(i\right)}\right) = Z \left({W}_{\left({b}_{1},{b}_{2},…,{b}_{k - 1}\right)}\right) = \left\{\begin{matrix}2 Z \left({W}_{\left({b}_{1},{b}_{2},…,{b}_{k - 1}\right)}\right) - Z {\left({W}_{\left({b}_{1},{b}_{2},…,{b}_{k - 1}\right)}\right)}^{2} , & if {b}_{k} = 0 \\ Z {\left({W}_{\left({b}_{1},{b}_{2},…,{b}_{k - 1}\right)}\right)}^{2} , & if {b}_{k} = 1\end{matrix}\right.$ Equation 13

For example, when the BEC has a binary probability of 0.5 and a code block size of 8, the values of Z(W) may be calculated according to Equation 11 as follows: Z(W) = {1.00, 0.68, 0.81, 0.12, 0.88, 0.19, 0.32, 0.00}. Thus, when the size of a data payload is 2, the data payload may be transmitted over equivalent channel 8 with Z(W) = 0.00 and equivalent channel 4 with Z(W) = 0.12.

As described above, since a polar encoder has different reliability depending on input positions, the transmitting side may allocate a data block (i.e., an information block before encoding) to bit channel(s) in order of reliability according to the size of the corresponding data block and perform encoding by setting all others to be frozen (e.g., with a value of '0'). For example, if the mother code size of the polar encoder (i.e., the maximum size of a code block that the polar encoder is capable of encoding) is N, and if the size of a data block input to the polar encoder is K, polar encoding is performed by arranging the bits of the data block in order of reliability in K bit channels and setting 0 to N-K bit channel(s).

The following shows the polar sequence used in NR (5G) systems (see the polar sequence defined in 3GPP TS 38.212 Rel-15).

### <Polar sequence>

| W | I | W | I | W | I | W | I | W | I | W | I | W | I | W | I |
|---|---|---|---|---|---|---|---|---|---|---|---|---|---|---|---|
| 0 | 0 | 128 | 518 | 256 | 94 | 384 | 214 | 512 | 364 | 640 | 414 | 768 | 819 | 896 | 966 |
| 1 | 1 | 129 | 54 | 257 | 204 | 385 | 309 | 513 | 654 | 641 | 223 | 769 | 814 | 897 | 755 |
| 2 | 2 | 130 | 83 | 258 | 298 | 386 | 188 | 514 | 659 | 642 | 663 | 770 | 439 | 898 | 859 |
| 3 | 4 | 131 | 57 | 259 | 400 | 387 | 449 | 515 | 335 | 643 | 692 | 771 | 929 | 899 | 940 |
| 4 | 8 | 132 | 521 | 260 | 608 | 388 | 217 | 516 | 480 | 644 | 835 | 772 | 490 | 900 | 830 |
| 5 | 16 | 133 | 112 | 261 | 352 | 389 | 408 | 517 | 315 | 645 | 619 | 773 | 623 | 901 | 911 |
| 6 | 32 | 134 | 135 | 262 | 325 | 390 | 609 | 518 | 221 | 646 | 472 | 774 | 671 | 902 | 871 |
| 7 | 3 | 135 | 78 | 263 | 533 | 391 | 596 | 519 | 370 | 647 | 455 | 775 | 739 | 903 | 639 |
| 8 | 5 | 136 | 289 | 264 | 155 | 392 | 551 | 520 | 613 | 648 | 796 | 776 | 916 | 904 | 888 |
| 9 | 64 | 137 | 194 | 265 | 210 | 393 | 650 | 521 | 422 | 649 | 809 | 777 | 463 | 905 | 479 |
| 10 | 9 | 138 | 85 | 266 | 305 | 394 | 229 | 522 | 425 | 650 | 714 | 778 | 843 | 906 | 946 |
| 11 | 6 | 139 | 276 | 267 | 547 | 395 | 159 | 523 | 451 | 651 | 721 | 779 | 381 | 907 | 750 |
| 12 | 17 | 140 | 522 | 268 | 300 | 396 | 420 | 524 | 614 | 652 | 837 | 780 | 497 | 908 | 969 |
| 13 | 10 | 141 | 58 | 269 | 109 | 397 | 310 | 525 | 543 | 653 | 716 | 781 | 930 | 909 | 508 |
| 14 | 18 | 142 | 168 | 270 | 184 | 398 | 541 | 526 | 235 | 654 | 864 | 782 | 821 | 910 | 861 |
| 15 | 128 | 143 | 139 | 271 | 534 | 399 | 773 | 527 | 412 | 655 | 810 | 783 | 726 | 911 | 757 |
| 16 | 12 | 144 | 99 | 272 | 537 | 400 | 610 | 528 | 343 | 656 | 606 | 784 | 961 | 912 | 970 |
| 17 | 33 | 145 | 86 | 273 | 115 | 401 | 657 | 529 | 372 | 657 | 912 | 785 | 872 | 913 | 919 |
| 18 | 65 | 146 | 60 | 274 | 167 | 402 | 333 | 530 | 775 | 658 | 722 | 786 | 492 | 914 | 875 |
| 19 | 20 | 147 | 280 | 275 | 225 | 403 | 119 | 531 | 317 | 659 | 696 | 787 | 631 | 915 | 862 |
| 20 | 256 | 148 | 89 | 276 | 326 | 404 | 600 | 532 | 222 | 660 | 377 | 788 | 729 | 916 | 758 |
| 21 | 34 | 149 | 290 | 277 | 306 | 405 | 339 | 533 | 426 | 661 | 435 | 789 | 700 | 917 | 948 |
| 22 | 24 | 150 | 529 | 278 | 772 | 406 | 218 | 534 | 453 | 662 | 817 | 790 | 443 | 918 | 977 |
| 23 | 36 | 151 | 524 | 279 | 157 | 407 | 368 | 535 | 237 | 663 | 319 | 791 | 741 | 919 | 923 |
| 24 | 7 | 152 | 196 | 280 | 656 | 408 | 652 | 536 | 559 | 664 | 621 | 792 | 845 | 920 | 972 |
| 25 | 129 | 153 | 141 | 281 | 329 | 409 | 230 | 537 | 833 | 665 | 812 | 793 | 920 | 921 | 761 |
| 26 | 66 | 154 | 101 | 282 | 110 | 410 | 391 | 538 | 804 | 666 | 484 | 794 | 382 | 922 | 877 |
| 27 | 512 | 155 | 147 | 283 | 117 | 411 | 313 | 539 | 712 | 667 | 430 | 795 | 822 | 923 | 952 |
| 28 | 11 | 156 | 176 | 284 | 212 | 412 | 450 | 540 | 834 | 668 | 838 | 796 | 851 | 924 | 495 |
| 29 | 40 | 157 | 142 | 285 | 171 | 413 | 542 | 541 | 661 | 669 | 667 | 797 | 730 | 925 | 703 |
| 30 | 68 | 158 | 530 | 286 | 776 | 414 | 334 | 542 | 808 | 670 | 488 | 798 | 498 | 926 | 935 |
| 31 | 130 | 159 | 321 | 287 | 330 | 415 | 233 | 543 | 779 | 671 | 239 | 799 | 880 | 927 | 978 |
| 32 | 19 | 160 | 31 | 288 | 226 | 416 | 555 | 544 | 617 | 672 | 378 | 800 | 742 | 928 | 883 |
| 33 | 13 | 161 | 200 | 289 | 549 | 417 | 774 | 545 | 604 | 673 | 459 | 801 | 445 | 929 | 762 |
| 34 | 48 | 162 | 90 | 290 | 538 | 418 | 175 | 546 | 433 | 674 | 622 | 802 | 471 | 930 | 503 |
| 35 | 14 | 163 | 545 | 291 | 387 | 419 | 123 | 547 | 720 | 675 | 627 | 803 | 635 | 931 | 925 |
| 36 | 72 | 164 | 292 | 292 | 308 | 420 | 658 | 548 | 816 | 676 | 437 | 804 | 932 | 932 | 878 |
| 37 | 257 | 165 | 322 | 293 | 216 | 421 | 612 | 549 | 836 | 677 | 380 | 805 | 687 | 933 | 735 |
| 38 | 21 | 166 | 532 | 294 | 416 | 422 | 341 | 550 | 347 | 678 | 818 | 806 | 903 | 934 | 993 |
| 39 | 132 | 167 | 263 | 295 | 271 | 423 | 777 | 551 | 897 | 679 | 461 | 807 | 825 | 935 | 885 |
| 40 | 35 | 168 | 149 | 296 | 279 | 424 | 220 | 552 | 243 | 680 | 496 | 808 | 500 | 936 | 939 |
| 41 | 258 | 169 | 102 | 297 | 158 | 425 | 314 | 553 | 662 | 681 | 669 | 809 | 846 | 937 | 994 |
| 42 | 26 | 170 | 105 | 298 | 337 | 426 | 424 | 554 | 454 | 682 | 679 | 810 | 745 | 938 | 980 |
| 43 | 513 | 171 | 304 | 299 | 550 | 427 | 395 | 555 | 318 | 683 | 724 | 811 | 826 | 939 | 926 |
| 44 | 80 | 172 | 296 | 300 | 672 | 428 | 673 | 556 | 675 | 684 | 841 | 812 | 732 | 940 | 764 |
| 45 | 37 | 173 | 163 | 301 | 118 | 429 | 583 | 557 | 618 | 685 | 629 | 813 | 446 | 941 | 941 |
| 46 | 25 | 174 | 92 | 302 | 332 | 430 | 355 | 558 | 898 | 686 | 351 | 814 | 962 | 942 | 967 |
| 47 | 22 | 175 | 47 | 303 | 579 | 431 | 287 | 559 | 781 | 687 | 467 | 815 | 936 | 943 | 886 |
| 48 | 136 | 176 | 267 | 304 | 540 | 432 | 183 | 560 | 376 | 688 | 438 | 816 | 475 | 944 | 831 |
| 49 | 260 | 177 | 385 | 305 | 389 | 433 | 234 | 561 | 428 | 689 | 737 | 817 | 853 | 945 | 947 |
| 50 | 264 | 178 | 546 | 306 | 173 | 434 | 125 | 562 | 665 | 690 | 251 | 818 | 867 | 946 | 507 |
| 51 | 38 | 179 | 324 | 307 | 121 | 435 | 557 | 563 | 736 | 691 | 462 | 819 | 637 | 947 | 889 |
| 52 | 514 | 180 | 208 | 308 | 553 | 436 | 660 | 564 | 567 | 692 | 442 | 820 | 907 | 948 | 984 |
| 53 | 96 | 181 | 386 | 309 | 199 | 437 | 616 | 565 | 840 | 693 | 441 | 821 | 487 | 949 | 751 |
| 54 | 67 | 182 | 150 | 310 | 784 | 438 | 342 | 566 | 625 | 694 | 469 | 822 | 695 | 950 | 942 |
| 55 | 41 | 183 | 153 | 311 | 179 | 439 | 316 | 567 | 238 | 695 | 247 | 823 | 746 | 951 | 996 |
| 56 | 144 | 184 | 165 | 312 | 228 | 440 | 241 | 568 | 359 | 696 | 683 | 824 | 828 | 952 | 971 |
| 57 | 28 | 185 | 106 | 313 | 338 | 441 | 778 | 569 | 457 | 697 | 842 | 825 | 753 | 953 | 890 |
| 58 | 69 | 186 | 55 | 314 | 312 | 442 | 563 | 570 | 399 | 698 | 738 | 826 | 854 | 954 | 509 |
| 59 | 42 | 187 | 328 | 315 | 704 | 443 | 345 | 571 | 787 | 699 | 899 | 827 | 857 | 955 | 949 |
| 60 | 516 | 188 | 536 | 316 | 390 | 444 | 452 | 572 | 591 | 700 | 670 | 828 | 504 | 956 | 973 |
| 61 | 49 | 189 | 577 | 317 | 174 | 445 | 397 | 573 | 678 | 701 | 783 | 829 | 799 | 957 | 1000 |
| 62 | 74 | 190 | 548 | 318 | 554 | 446 | 403 | 574 | 434 | 702 | 849 | 830 | 255 | 958 | 892 |
| 63 | 272 | 191 | 113 | 319 | 581 | 447 | 207 | 575 | 677 | 703 | 820 | 831 | 964 | 959 | 950 |
| 64 | 160 | 192 | 154 | 320 | 393 | 448 | 674 | 576 | 349 | 704 | 728 | 832 | 909 | 960 | 863 |
| 65 | 520 | 193 | 79 | 321 | 283 | 449 | 558 | 577 | 245 | 705 | 928 | 833 | 719 | 961 | 759 |
| 66 | 288 | 194 | 269 | 322 | 122 | 450 | 785 | 578 | 458 | 706 | 791 | 834 | 477 | 962 | 1008 |
| 67 | 528 | 195 | 108 | 323 | 448 | 451 | 432 | 579 | 666 | 707 | 367 | 835 | 915 | 963 | 510 |
| 68 | 192 | 196 | 578 | 324 | 353 | 452 | 357 | 580 | 620 | 708 | 901 | 836 | 638 | 964 | 979 |
| 69 | 544 | 197 | 224 | 325 | 561 | 453 | 187 | 581 | 363 | 709 | 630 | 837 | 748 | 965 | 953 |
| 70 | 70 | 198 | 166 | 326 | 203 | 454 | 236 | 582 | 127 | 710 | 685 | 838 | 944 | 966 | 763 |
| 71 | 44 | 199 | 519 | 327 | 63 | 455 | 664 | 583 | 191 | 711 | 844 | 839 | 869 | 967 | 974 |
| 72 | 131 | 200 | 552 | 328 | 340 | 456 | 624 | 584 | 782 | 712 | 633 | 840 | 491 | 968 | 954 |
| 73 | 81 | 201 | 195 | 329 | 394 | 457 | 587 | 585 | 407 | 713 | 711 | 841 | 699 | 969 | 879 |
| 74 | 50 | 202 | 270 | 330 | 527 | 458 | 780 | 586 | 436 | 714 | 253 | 842 | 754 | 970 | 981 |
| 75 | 73 | 203 | 641 | 331 | 582 | 459 | 705 | 587 | 626 | 715 | 691 | 843 | 858 | 971 | 982 |
| 76 | 15 | 204 | 523 | 332 | 556 | 460 | 126 | 588 | 571 | 716 | 824 | 844 | 478 | 972 | 927 |
| 77 | 320 | 205 | 275 | 333 | 181 | 461 | 242 | 589 | 465 | 717 | 902 | 845 | 968 | 973 | 995 |
| 78 | 133 | 206 | 580 | 334 | 295 | 462 | 565 | 590 | 681 | 718 | 686 | 846 | 383 | 974 | 765 |
| 79 | 52 | 207 | 291 | 335 | 285 | 463 | 398 | 591 | 246 | 719 | 740 | 847 | 910 | 975 | 956 |
| 80 | 23 | 208 | 59 | 336 | 232 | 464 | 346 | 592 | 707 | 720 | 850 | 848 | 815 | 976 | 887 |
| 81 | 134 | 209 | 169 | 337 | 124 | 465 | 456 | 593 | 350 | 721 | 375 | 849 | 976 | 977 | 985 |
| 82 | 384 | 210 | 560 | 338 | 205 | 466 | 358 | 594 | 599 | 722 | 444 | 850 | 870 | 978 | 997 |
| 83 | 76 | 211 | 114 | 339 | 182 | 467 | 405 | 595 | 668 | 723 | 470 | 851 | 917 | 979 | 986 |
| 84 | 137 | 212 | 277 | 340 | 643 | 468 | 303 | 596 | 790 | 724 | 483 | 852 | 727 | 980 | 943 |
| 85 | 82 | 213 | 156 | 341 | 562 | 469 | 569 | 597 | 460 | 725 | 415 | 853 | 493 | 981 | 891 |
| 86 | 56 | 214 | 87 | 342 | 286 | 470 | 244 | 598 | 249 | 726 | 485 | 854 | 873 | 982 | 998 |
| 87 | 27 | 215 | 197 | 343 | 585 | 471 | 595 | 599 | 682 | 727 | 905 | 855 | 701 | 983 | 766 |
| 88 | 97 | 216 | 116 | 344 | 299 | 472 | 189 | 600 | 573 | 728 | 795 | 856 | 931 | 984 | 511 |
| 89 | 39 | 217 | 170 | 345 | 354 | 473 | 566 | 601 | 411 | 729 | 473 | 857 | 756 | 985 | 988 |
| 90 | 259 | 218 | 61 | 346 | 211 | 474 | 676 | 602 | 803 | 730 | 634 | 858 | 860 | 986 | 1001 |
| 91 | 84 | 219 | 531 | 347 | 401 | 475 | 361 | 603 | 789 | 731 | 744 | 859 | 499 | 987 | 951 |
| 92 | 138 | 220 | 525 | 348 | 185 | 476 | 706 | 604 | 709 | 732 | 852 | 860 | 731 | 988 | 1002 |
| 93 | 145 | 221 | 642 | 349 | 396 | 477 | 589 | 605 | 365 | 733 | 960 | 861 | 823 | 989 | 893 |
| 94 | 261 | 222 | 281 | 350 | 344 | 478 | 215 | 606 | 440 | 734 | 865 | 862 | 922 | 990 | 975 |
| 95 | 29 | 223 | 278 | 351 | 586 | 479 | 786 | 607 | 628 | 735 | 693 | 863 | 874 | 991 | 894 |
| 96 | 43 | 224 | 526 | 352 | 645 | 480 | 647 | 608 | 689 | 736 | 797 | 864 | 918 | 992 | 1009 |
| 97 | 98 | 225 | 177 | 353 | 593 | 481 | 348 | 609 | 374 | 737 | 906 | 865 | 502 | 993 | 955 |
| 98 | 515 | 226 | 293 | 354 | 535 | 482 | 419 | 610 | 423 | 738 | 715 | 866 | 933 | 994 | 1004 |
| 99 | 88 | 227 | 388 | 355 | 240 | 483 | 406 | 611 | 466 | 739 | 807 | 867 | 743 | 995 | 1010 |
| 100 | 140 | 228 | 91 | 356 | 206 | 484 | 464 | 612 | 793 | 740 | 474 | 868 | 760 | 996 | 957 |
| 101 | 30 | 229 | 584 | 357 | 95 | 485 | 680 | 613 | 250 | 741 | 636 | 869 | 881 | 997 | 983 |
| 102 | 146 | 230 | 769 | 358 | 327 | 486 | 801 | 614 | 371 | 742 | 694 | 870 | 494 | 998 | 958 |
| 103 | 71 | 231 | 198 | 359 | 564 | 487 | 362 | 615 | 481 | 743 | 254 | 871 | 702 | 999 | 987 |
| 104 | 262 | 232 | 172 | 360 | 800 | 488 | 590 | 616 | 574 | 744 | 717 | 872 | 921 | 1000 | 1012 |
| 105 | 265 | 233 | 120 | 361 | 402 | 489 | 409 | 617 | 413 | 745 | 575 | 873 | 501 | 1001 | 999 |
| 106 | 161 | 234 | 201 | 362 | 356 | 490 | 570 | 618 | 603 | 746 | 913 | 874 | 876 | 1002 | 1016 |
| 107 | 576 | 235 | 336 | 363 | 307 | 491 | 788 | 619 | 366 | 747 | 798 | 875 | 847 | 1003 | 767 |
| 108 | 45 | 236 | 62 | 364 | 301 | 492 | 597 | 620 | 468 | 748 | 811 | 876 | 992 | 1004 | 989 |
| 109 | 100 | 237 | 282 | 365 | 417 | 493 | 572 | 621 | 655 | 749 | 379 | 877 | 447 | 1005 | 1003 |
| 110 | 640 | 238 | 143 | 366 | 213 | 494 | 219 | 622 | 900 | 750 | 697 | 878 | 733 | 1006 | 990 |
| 111 | 51 | 239 | 103 | 367 | 568 | 495 | 311 | 623 | 805 | 751 | 431 | 879 | 827 | 1007 | 1005 |
| 112 | 148 | 240 | 178 | 368 | 832 | 496 | 708 | 624 | 615 | 752 | 607 | 880 | 934 | 1008 | 959 |
| 113 | 46 | 241 | 294 | 369 | 588 | 497 | 598 | 625 | 684 | 753 | 489 | 881 | 882 | 1009 | 1011 |
| 114 | 75 | 242 | 93 | 370 | 186 | 498 | 601 | 626 | 710 | 754 | 866 | 882 | 937 | 1010 | 1013 |
| 115 | 266 | 243 | 644 | 371 | 646 | 499 | 651 | 627 | 429 | 755 | 723 | 883 | 963 | 1011 | 895 |
| 116 | 273 | 244 | 202 | 372 | 404 | 500 | 421 | 628 | 794 | 756 | 486 | 884 | 747 | 1012 | 1006 |
| 117 | 517 | 245 | 592 | 373 | 227 | 501 | 792 | 629 | 252 | 757 | 908 | 885 | 505 | 1013 | 1014 |
| 118 | 104 | 246 | 323 | 374 | 896 | 502 | 802 | 630 | 373 | 758 | 718 | 886 | 855 | 1014 | 1017 |
| 119 | 162 | 247 | 392 | 375 | 594 | 503 | 611 | 631 | 605 | 759 | 813 | 887 | 924 | 1015 | 1018 |
| 120 | 53 | 248 | 297 | 376 | 418 | 504 | 602 | 632 | 848 | 760 | 476 | 888 | 734 | 1016 | 991 |
| 121 | 193 | 249 | 770 | 377 | 302 | 505 | 410 | 633 | 690 | 761 | 856 | 889 | 829 | 1017 | 1020 |
| 122 | 152 | 250 | 107 | 378 | 649 | 506 | 231 | 634 | 713 | 762 | 839 | 890 | 965 | 1018 | 1007 |
| 123 | 77 | 251 | 180 | 379 | 771 | 507 | 688 | 635 | 632 | 763 | 725 | 891 | 938 | 1019 | 1015 |
| 124 | 164 | 252 | 151 | 380 | 360 | 508 | 653 | 636 | 482 | 764 | 698 | 892 | 884 | 1020 | 1019 |
| 125 | 768 | 253 | 209 | 381 | 539 | 509 | 248 | 637 | 806 | 765 | 914 | 893 | 506 | 1021 | 1021 |
| 126 | 268 | 254 | 284 | 382 | 111 | 510 | 369 | 638 | 427 | 766 | 752 | 894 | 749 | 1022 | 1022 |
| 127 | 274 | 255 | 648 | 383 | 331 | 511 | 190 | 639 | 904 | 767 | 868 | 895 | 945 | 1023 | 1023 |

The above table shows a Polar sequence **Q**₀^{N^{max-1}} and a reliability *W*(*Qᵢ*^{Nmax}) of the Polar sequence. In the above table, W denotes *W*(*Q*ᵢ^{Nmax}) and I denotes *Q*ᵢ^{Nmax}. Namely, the Polar sequence **Q**₀^{Nmax-1} = {*Q*₀^{Nmax}, Q₁^{Nmax},..., Q_{Nmax-1}^{Nmax}} is given by the above table, where 0<=*Q*ᵢ^{Nmax}<=Nmax-1 denotes a bit indices (i.e., bit channel indices) before Polar encoding for i=0,1,...,Nmax-1. For 3GPP TS 38.212 Rel-15, Nmax = 1024. The Polar sequence **Q**₀^{Nmax-1} is ascending order of reliability *W*(*Q*₀^{Nmax})<*W*(Q₁^{Nmax})< ...<*W*(*Q*_{Nmax-1}^{Nmax}), where *W*(*Q*ᵢ^{Nmax}) denotes the reliability of bit index *Q*ᵢ^{Nmax}. For example, referring to the above table, a reliability *W*(*Q*ᵢ^{Nmax})=3 of a bit indices *Q*ᵢ^{Nmax}=4 is lower than a reliability *W*(*Q*ᵢ^{Nmax})=7 of bit index *Q*ᵢ^{Nmax}=3. That is, the above table lists, in ascending order of reliability, bit indices 0 to 1023 which respectively indicate 1024 input positions of a polar code of Nmax=1024.

For any information block encoded to N bits, the same Polar sequence **Q**₀^{N-1} = {*Q*₀^{N}, *Q*₁^{N}, *Q*₂^{N},..., *Q*_{N-1}^{N}} is used. The Polar sequence **Q**₀^{N-1} is a subset of the Polar sequence **Q**₀^{Nmax-1} with all elements *Q*ᵢ^{Nmax} of values less than N, ordered in ascending order of reliability *W*(*Q*₀^{N})<*W*(*Q*₁^{N})<*W*(*Q*₂^{N})<...<*W*(*Q*_{N-1}^{N}). For example, when N=8, the Polar sequence **Q**₀⁷ includes elements of *Q*ᵢ^{Nmax}<8 among elements of the Polar sequence **Q**₀^{Nmax-1} and the elements of *Q*ᵢ^{Nmax}<8 are ordered in ascending order of reliability *W*(0)<*W*(1)<*W*(2)<*W*(4)<*W*(3)<*W*(5)<*W*(6).

For example, Table 3 lists input bit positions for an information block of size K (=10) input to a polar code in a Polar sequence of N=512.

**Table 3**

| | Polar sequence |
|---|---|
| 1 | 505 |
| 2 | 506 |
| 3 | 479 |
| 4 | 508 |
| 5 | 495 |
| 6 | 503 |
| 7 | 507 |
| 8 | 509 |
| 9 | 510 |
| 10 | 511 |

Table 3 shows 10 elements for K=10 among elements of the Polar sequence of N=512 in ascending order of reliability. Referring to the above-described table of <Polar sequence>, the top 10 values of I in terms of reliability *W*(*Q*ᵢ^{Nmax}) among values of I (=*Q*ᵢ^{Nmax}) less than N=512 are {479, 495, 503, 505, 506, 507, 508, 509, 510, 511}. If {479, 495, 503, 505, 506, 507, 508, 509, 510, 511} are arranged in ascending order of reliability *W*, {505, 506, 479, 508, 495, 503, 507, 509, 510, 511}, which is a set of bit indices for K=10 in the Polar sequence of N=512 shown in Table 3, may be obtained.

If the bit sequence input to channel coding is denoted by c₀,c₁,c₂,c₃,...,c_{K-1}, the bits after encoding are denoted by d₀,d₁,d₂,d₃,...,d_{N-1}, where K is the number of bits to encode, where N=2ⁿ.

For any information block encoded to N bits, the same Polar sequence **Q**₀^{N-1} = {*Q*₀^{N}, *Q*₁^{N}, *Q*₂^{N},..., *Q*_{N-1}^{N}} is used. The Polar sequence **Q**₀^{N-1} is a subset of the Polar sequence **Q**₀^{Nmax-1} with all elements *Q*ᵢ^{Nmax} of values less than N, ordered in ascending order of reliability *W*(*Q*₀^{N})<*W*(*Q*₁^{N})<*W*(*Q*₂^{N})<...<*W*(*Q*_{N-1}^{N}).

Assuming that an input to polar encoding is **u** = [u₀ u₁ u₂ ... u_{N-1}], in some implementations, the output after encoding, **d** = [d₀ d₁ d₂ d₃ ... d_{N-1}], may be obtained by **d** = **uG**_{N}, and the encoding may be performed over GF(2).

A list successive cancellation decoder used for conventional polar code decoding has disadvantages in that implementation complexity and latency are high because a sorting operation is performed for each bit. To address this issue, a permutation decoding scheme in which decoding is performed by permuting an order of received signals has been proposed.

When a vector **π**(c), obtained by rearranging a codeword **c** of a code ***C*** having a length N=2ⁿ with a permutation **π**, belongs to the original code ***C***, the permutation may be referred to as an automorphism. A permutation decoder generates candidate vectors by permuting received signals using a plurality of automorphisms and decodes the candidate vectors in parallel. Accordingly, unlike an SCL decoder, the permutation decoder may achieve full parallelization and may not require a sorter, thereby dramatically reducing implementation complexity and latency. In this case, it may be assumed that the received signals are transmitted through an additive white Gaussian noise (AWGN) channel having a variance of σ².

To apply permutation decoding, it is important to identify an automorphism, which is a permutation under which a codeword remains a codeword even when an order of codes is permuted. For polar codes, for example, an automorphism in the form of an affine transformation may be identified according to the selection of an information set. Polar codes include an automorphism in the form of a block lower triangular affine (BLTA) transformation. The BLTA transformation is defined by a block structure s = (s₀, s₁, ..., sₜ₋₁) according to the selection of the information set. For a binary vector **z** = (z₀, z₁, ..., zₙ₋₁) of an index i of a bit in each codeword, a BLTA transformation process may involve a transformation defined as follows.$z ′ ← A z + b , A = \left[\begin{matrix}{B}_{0 , 0} & 0 & ⋯ & 0 \\ {B}_{1 , 0} & {B}_{1 , 1} & ⋯ & 0 \\ ⋮ & ⋮ & ⋱ & ⋮ \\ {B}_{t - 1 , 0} & {B}_{t - 1 , 1} & ⋯ & {B}_{t - 1 , t - 1}\end{matrix}\right] , b ∈ {F}_{2}^{n}$ Equation 14

Here, B_{i,i} may be an invertible matrix of sᵢ*sᵢ. According to the structure of s, the BLTA transformation may be referred to as a lower triangular affine transformation (s = (1, 1, ..., 1)) or a general affine transformation (s = (n)).

Among automorphisms of a polar code, some automorphisms output an identical successive cancellation decoding result during permutation decoding, and such automorphisms may be referred to as successive cancellation invariant automorphisms. During permutation decoding of a polar code, when successive cancellation variant automorphisms are used, each decoding path may provide an individual estimated value for a transmitted message, and the individual estimated value may be used to provide information on the transmitted message.

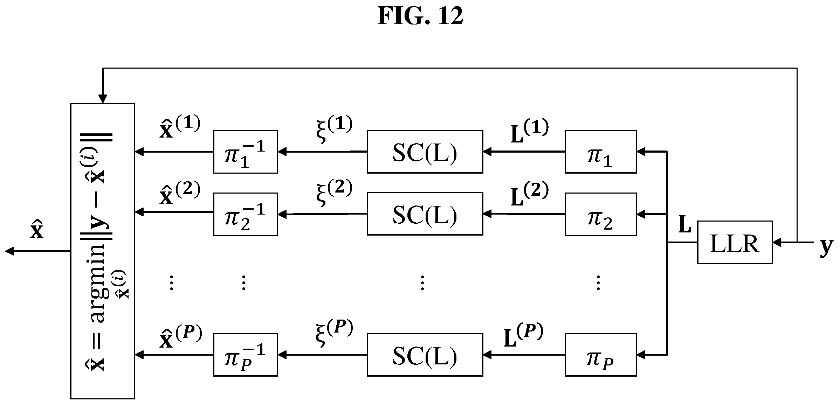

FIG. 12 illustrates an example of a permutation decoder. In FIG. 12, **L** is obtained by converting a channel output **y** into a log likelihood ratio (LLR) form. For an AWGN channel, **L** and the channel output **y** may satisfy the following relationship: **L** = 2**y**/σ², where σ² denotes a Gaussian distribution.

A message vector, that is, an input to a polar encoding block having a size N, may be divided into N-K frozen bits and K information bits. Since the structure of a polar code and the rate matching structure for a codeword are known to a transmitter and a receiver, the receiver may obtain a channel bit sequence **y** having a length N from a bit sequence received through a physical channel, and may convert the channel bit sequence **y** into an LLR form.

A successive cancellation (SC) or list successive cancellation (list-SC) decoder of a polar code (corresponding to the SC(L) block of FIG. 12) sequentially calculates LLRs L⁽⁰⁾, L⁽¹⁾, ..., L^{(N-1)} of a message from LLRs L₀, L₁, ..., L_{N-1} of a channel. In this case, a polarization phenomenon occurs in the distribution of the message LLRs, and, as the length N of the code increases, some message LLRs have reliability close to 0, while some message LLRs have reliability close to ∞. In this case, a message having reliability of 0 is set to a value shared by the receiver and the transmitter, and communication may be performed by carrying an actual message in a message having reliability of infinity. In the decoding process, channel LLRs are used within the graph structure of the polar code to calculate LLR values of messages (i.e., codeword bits), and the calculated LLR values are used to determine bit values of the polar code. In this case, among input bits of the polar code, since a bit value corresponding to a frozen bit is a value shared/known in advance between the transmitter and the receiver, a corresponding channel LLR value may be set to infinity, and polar decoding may be performed accordingly. In the decoding process of the polar code, a message vector transmitted by the transmitter is estimated based on output message LLR information. For example, when an LLR value L⁽ⁱ⁾>0, an i-th message bit is determined to be "0."

Referring to FIG. 12, in some implementations, a permutation decoder generates P decoding paths, applies different permutations to the P decoding paths to perform decoding, and performs permutation decoding by selecting a codeword closest to a received signal. Each decoding path outputs an individual estimated value for a transmitted message, and different estimated values output from all decoding paths provide a diversity gain for the transmitted message. In other words, permutation decoding independently estimates a transmitted codeword for each decoding path i and obtains an estimated value ${\hat{x}}^{\left(i\right)} = \left({\hat{x}}_{0}^{\left(i\right)},{\hat{x}}_{1}^{\left(i\right)},…,{\hat{x}}_{N - 1}^{\left(i\right)}\right)$, thereby providing a diversity gain in estimation of the transmitted codeword.

In permutation decoding, when decoding fails for all decoding paths, a decoding failure is output without any additional attempt.

A conventional permutation decoder performs decoding for multiple SC decoding paths and needs to make multiple SC decoding attempts each time. This increases decoding complexity relative to decoding performance.

To address the problems of the conventional permutation decoding, a decoder or decoding process according to some implementations of the present disclosure is described, in which decoding is not completed for paths determined to have low reliability, while decoding is completed only for decoding paths considered to have relatively high reliability. According to some implementations of the present disclosure, decoding complexity may be reduced compared to the conventional permutation decoding while substantially the same performance as the conventional permutation decoding that decodes all paths to completion may be achieved.

In the decoding method or decoder according to some implementations of the present disclosure, the reliability of each decoding path is determined based on a comparison between the minimum log likelihood ratio (LLR) value of the decoding path during decoding and a predefined boundary value in a parallel decoding process for decoding paths.

Because the minimum LLR value of each decoding path is determined according to a signal-to-noise ratio (SNR) value of a channel, two boundary values (i.e., thresholds) τ₁ and τ₂ for determining the reliability of a decoding path may be set/defined for application to various channels in some implementations of the present disclosure. Using these boundary values, the decoding method or decoder according to some implementations of the present disclosure may discontinue decoding for paths determined to have low reliability and continue decoding to completion only for decoding paths considered to have relatively high reliability. Through this approach, estimation value(s) may be obtained for the path(s) for which decoding is completed, as illustrated in FIG. 12, and among the obtained estimation value(s), an estimation value closest to the received signal **y** may be selected as a codeword and output as an overall decoding result. In some implementations, each of the thresholds τ₁ and τ₂ may be determined through a trial-and-error method in which arbitrary values are tested and a value providing good performance and low complexity is selected.

A permutation decoder is not capable of early decoding termination based on distributed CRC because the characteristics of distributed CRC may not be maintained due to the application of permutation, and permutation decoding requires performing inverse permutation and CRC checking after decoding all information bits to which permutation has been applied. In contrast, according to some implementations of the present disclosure described below, unlike the distributed CRC method disclosed in the 5G NR standard document (e.g., the interleaving disclosed in Section 5.3.1.1 or **u** for n_{PC}>0 disclosed in Section 5.3.1.2 in Rel-15 3GPP TS 38.212), the disclosed technique is advantageous over distributed CRC in that it may also be used in a permutation decoder.

The decoder or decoding method according to some implementations of the present disclosure, which will be described below, determines the reliability of each decoding path using the minimum LLR value of the decoding path during permutation decoding of a polar code, and performs decoding only for paths having high reliability, thereby reducing decoding complexity. The decoding method according to some implementations of the present disclosure will be described below.

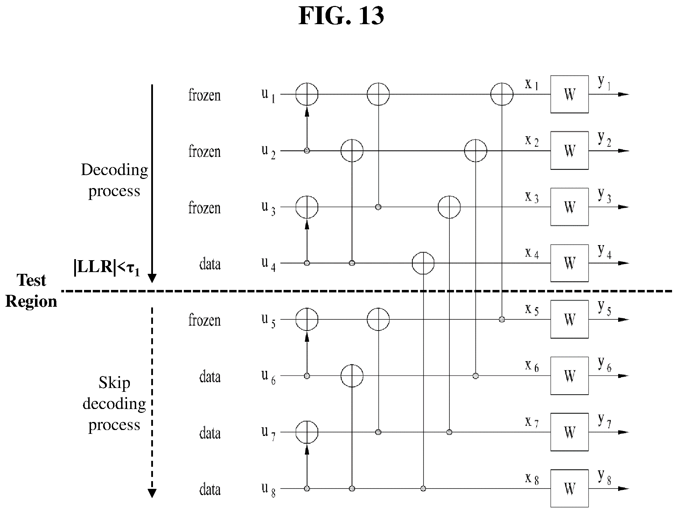

FIG. 13 illustrates an exemplary decoding process according to some implementations of the present disclosure.

As one method for reducing decoding complexity, it may be considered to early terminate a decoding process for unreliable decoding paths.

In some implementations of the present disclosure, the reliability of each decoding path may be estimated using the minimum LLR value of the decoding path obtained during an SC decoding process, in order to achieve substantially the same performance as conventional permutation decoding while reducing complexity.

SC decoding performance is determined by a bit having the lowest reliability. Accordingly, when a data bit having an LLR value smaller than a predefined boundary value (hereinafter, τ₁) exists during an SC decoding process, the decoder or decoding method according to some implementations of the present disclosure determines that a corresponding decoding path has low reliability and stops or terminates decoding for the decoding path, by utilizing the characteristic that SC decoding performance is determined by a data bit (also referred to as an information bit) having a minimum LLR value, as illustrated in FIG. 13.

The decoding method illustrated in FIG. 13 has a significant effect in a channel having a low SNR value. This is because, when the SNR of the channel is low, the minimum LLR value of each decoding path is likely to be low.

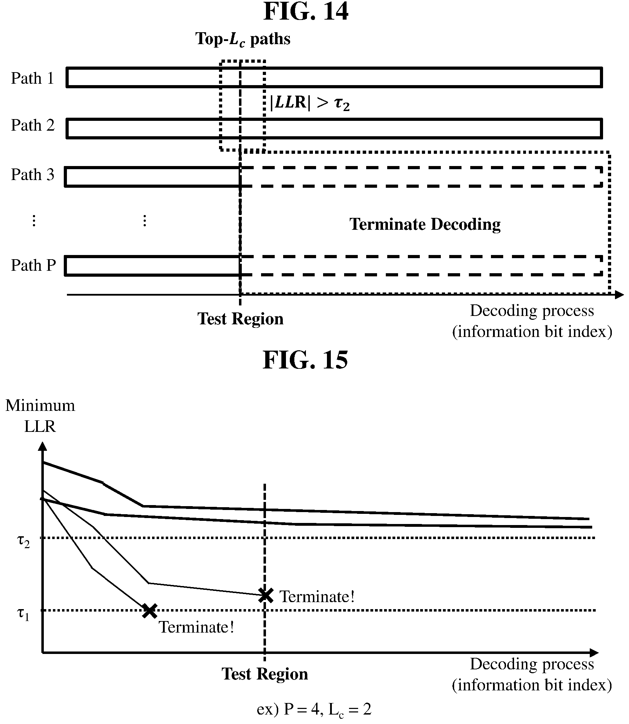

FIG. 14 illustrates another exemplary decoding process according to some implementations of the present disclosure.

The implementations of the present disclosure described with reference to FIG. 13 reduce complexity by identifying a path having a high probability of decoding failure in advance and terminating decoding for the path during parallel SC decoding. In a channel having a high SNR value, the minimum LLR value of each decoding path tends to be relatively large. Accordingly, for a channel having a high SNR value, the number of paths terminated during decoding by the boundary value τ₁ is extremely small, which may not reduce complexity. In consideration of this aspect, as another or additional method for reducing decoding complexity, reducing the number of paths to be decoded may be considered. A decoder or decoding method according to some implementations of the present disclosure may reduce decoding complexity by identifying, in advance, path(s) having a high probability of successful decoding and completing decoding only for the decoding path(s).

In some implementations of the present disclosure, a new boundary value (hereinafter, τ₂), which serves as a reference for determining the reliability of each decoding path, and the number L_{c} of paths for which decoding is actually completed may be used. One of the primary objectives of some implementations of the present disclosure is to effectively reduce complexity while achieving performance similar to that obtained by using all decoding paths of a given polar decoder. To achieve this objective, when decoding paths are classified based on a fixed boundary value τ₂, the SNR value of a channel to which the decoding method according to some implementations illustrated in FIG. 14 is applied increases, and the resulting increase in the number of paths considered to have high reliability reduces the effectiveness of the method. Accordingly, in the decoder or decoding method according to some implementations of the present disclosure, the minimum LLR values of decoding paths that are primarily determined to have high reliability based on the new boundary value τ₂ are sorted, L_{c} path(s) having the largest minimum LLR values are finally selected, and decoding is completed only for the selected path(s). The decoding process may be performed using τ₂ and L_{c}, as illustrated in FIG. 14. To efficiently reduce complexity, the new boundary value τ₂ for determining the reliability of each decoding path is applied in the middle of SC decoding (e.g., to specific bit(s) in the SC decoding process corresponding to the path). In the present disclosure, the corresponding position is referred to as a test region, and corresponds to the weakest M^{th} information bit (i.e., bit index M used as a data bit and having the highest error probability among the bit indices of a polar code). In some implementations of the present disclosure, to effectively identify paths having low reliability, t least reliable bits may be selected as a test region from among K information bits. In some implementations of the present disclosure, the test region includes bit(s) having the highest error probability, and the size of the test region will be described later. M representing the test region is selected such that a data bit having a high probability of exhibiting a small LLR value is effectively included by using the probability density functions (PDFs) of all respective data bits. The method described with reference to FIG. 14, that is, the method using τ₂ and L_{c}, may effectively reduce decoding complexity in a channel having a high SNR value, unlike the method using τ₁ described with reference to FIG. 13.

The method described with reference to FIG. 13 and the method described with reference to FIG. 14 may be applied separately or together.

FIG. 15 illustrates changes in the minimum LLR values of respective decoding paths in sequential decoding according to bit indices in which data/information is arranged (hereinafter, data bit indices or information bit indices). In the example of FIG. 15, it is assumed that the number of decoding paths P = 4 and L_{c} = 2. Referring to FIG. 15, it may be seen that τ₁ is dominant in a low-SNR region, whereas τ₂ and L_{c} are dominant in a high-SNR region. As illustrated in FIG. 15, decoding complexity may be effectively reduced for channels having various SNR values by using the method described with reference to FIG. 13 together with the method described with reference to FIG. 14.

In low-complexity permutation SC decoding according to some implementations of the present disclosure, early decoding termination is performed by comparing the minimum LLR values of test points in a test region with given thresholds τ₁ and τ₂. The size of the test region (i.e., the number of test points) may be determined based on the reliabilities of information bits (i.e., data bits). For example, the size of the test region may be determined as follows.

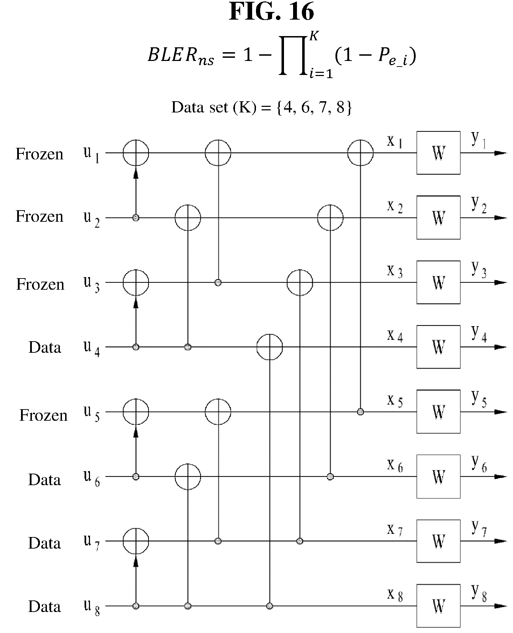

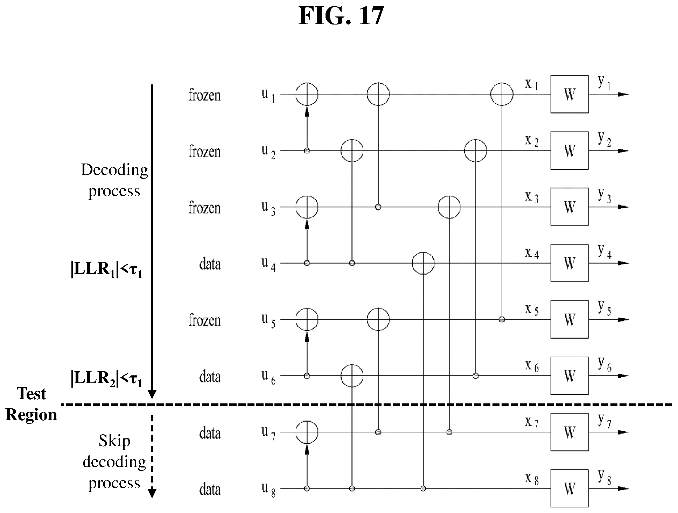

FIGS. 16 and 17 illustrate a method for determining the size of a test region according to some implementations of the present disclosure.

The block error rate (BLER) of a conventional permutation SC decoding path may be expressed as follows.${BLER}_{ns} = 1 - {\prod }_{i = 1}^{K} \left(1-{P}_{e _ i}\right)$ Equation 15

In FIG. 16 and Equation 15 above, BLERₙₛ denotes the BLER of a non-skipped path, P_{e_i} denotes the error probability of an i^{th} bit among the information bits, and K denotes the number of information bits (i.e., data bits). In the example of FIG. 16, K = 4, and a set of the most reliable bit indices among bit indices 1 to 8 input to the polar encoder is {4, 6, 7, 8}.

Referring to FIG. 17, when a test region including t test points in the above equation is expressed as I_{T}= {1, 2, ..., t}, the BLER of a path for which decoding is early terminated according to some implementations of the present disclosure may be expressed as follows.${BLER}_{l} = 1 - {\prod }_{i ∈ {I}_{T}} \left(1-{P}_{e _ i}\left({τ}_{1}\right)\right)$ Equation 16

BLER₁ denotes the BLER of path l for which decoding is terminated by τ₁, and P_{e_i}(τ₁) denotes the error probability of the i^{th} bit when the absolute LLR value of the i^{th} bit is smaller than τ₁.

In some implementations of the present disclosure, the test region may be determined to satisfy the following two conditions:
1) The test region includes a bit having the highest error probability; and
2) The size of the test region should be guaranteed to satisfy *BLERₙₛ* ≅ *BLERₗ* That is, it should be guaranteed that BLERₙₛ and BLERₗ are approximately equal.

That is, the test region should satisfy the above two conditions, and through this, t bits having the highest error probabilities are included in the test region.

In order to represent the degree of complexity reduction achieved through some implementations of the present disclosure, two metrics may be considered. A first metric is expressed from the perspective of decoding paths, and represents the ratio of the number of paths for which decoding is terminated during decoding by the two boundary values τ₁ and τ₂ according to some implementations of the present disclosure to the total number of decoding paths of the polar decoder illustrated in FIG. 12. The first metric may be expressed as follows.$Skipped path raito = \frac{number of terminated paths}{number of total paths \left(=P\right)}$ Equation 17

The other metric is expressed from the perspective of data bits for which decoding is performed, and represents the ratio of the number of data bits that need not be decoded due to termination of decoding during the decoding process to the number of data bits that should be decoded in the conventional polar decoder of FIG. 12. In the following equation below representing this metric, K denotes the total number of data bits included in a codeword.$Skipped bits raito = \frac{number of skipped bits for decoding}{number of total bits to be decoded \left(=P∗K\right)}$ Equation 18

In a polar code, the reliability of each information bit may be determined by a code structure. An (N, K) code structure depends on the size N of the polar code and the number K of information bits input to a polar encoding block, and K bit indices in which the K information bits are arranged among N bit indices (i.e., bit positions) of the polar code may be determined according to the reliabilities of the bit indices.

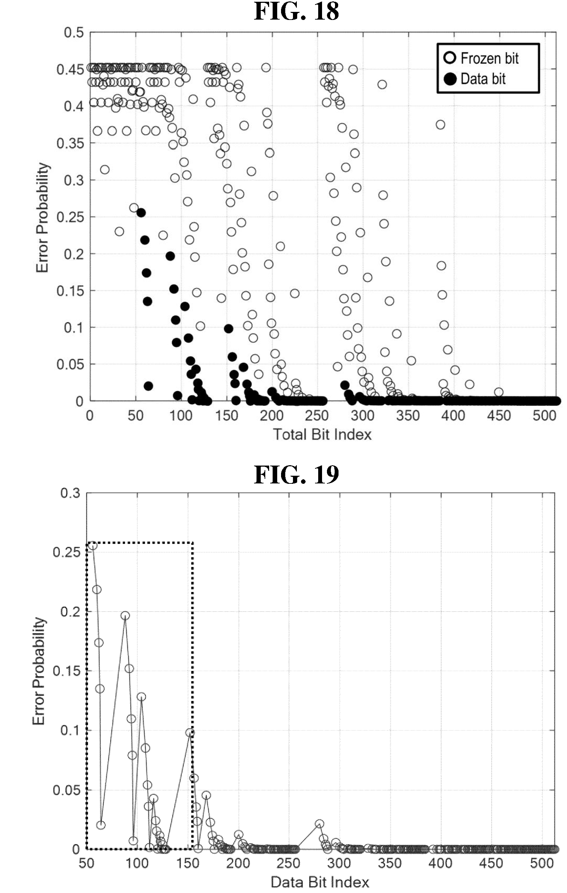

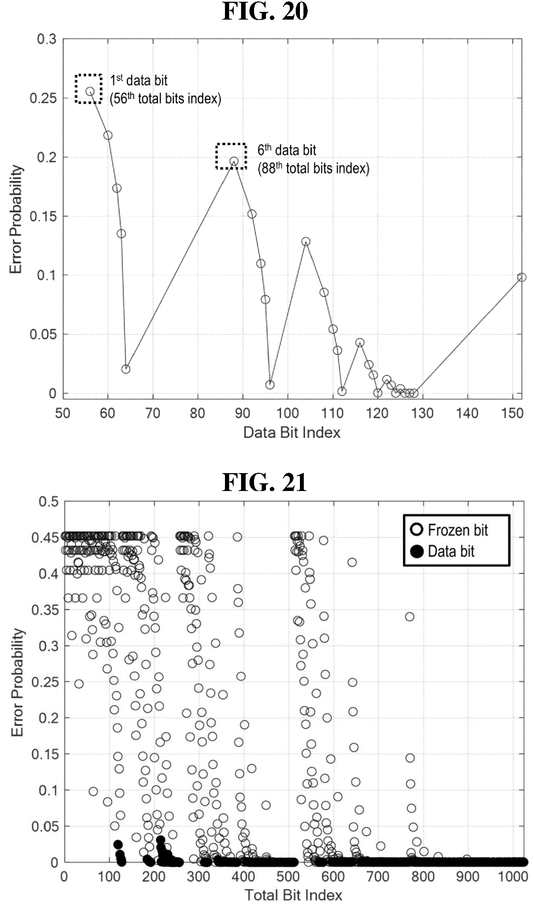

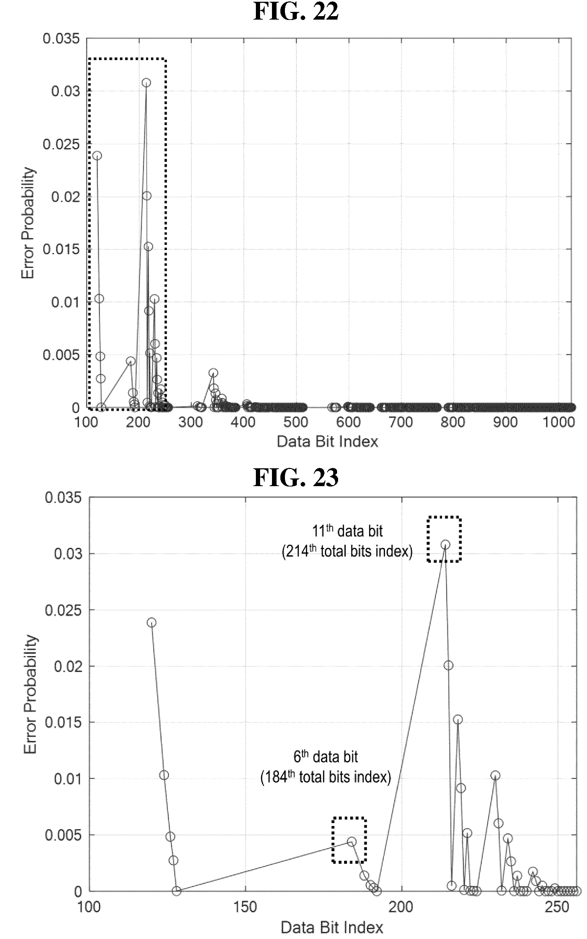

FIGS. 18 to 23 illustrate bit error probabilities for code structures. Specifically, FIGS. 18 to 20 illustrate bit error probabilities for a channel with a channel SNR of 2dB using a polar code with (N, K) = (512, 251), and FIGS. 21 to 23 illustrate bit error probabilities for a channel with a channel SNR of 3dB using a polar code with (N, K) = (1024, 517). Referring to FIGS. 18 to 23, it may be seen that, in view of the nature of the polar code, the error probabilities of earlier information bits tend to be greater than those of later information bits. Accordingly, SC decoding complexity may be reduced even when τ₁ is applied only to the earlier information bits. Since SC decoding of a polar code is dominantly affected by an information bit having the highest error probability, the reliability of SC decoding may be identified through an information bit having the highest reliability.

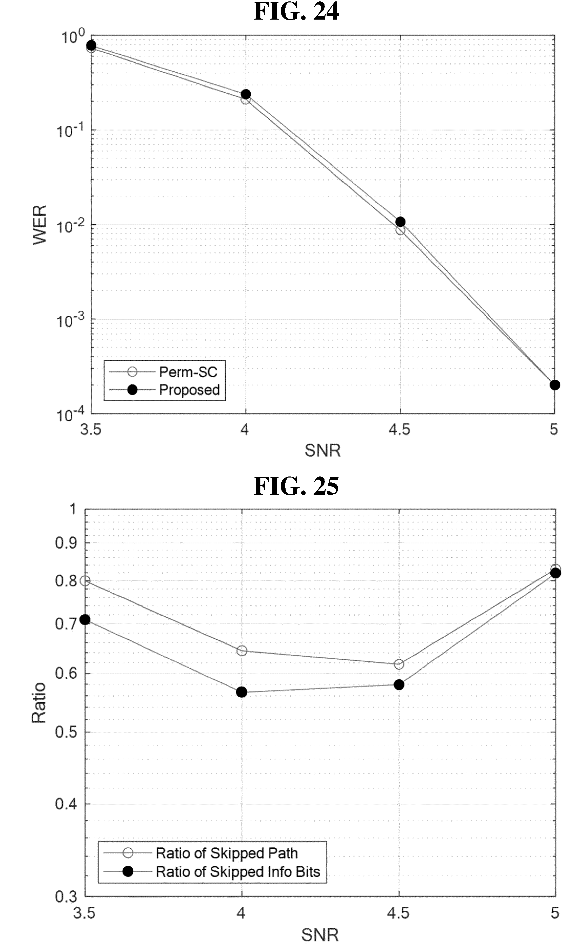

FIGS. 24 and 25 illustrate the word error ratio (WER) and complexity performance of a decoding method according to some implementations of the present disclosure. Specifically, FIGS. 24 and 25 illustrate the WER and complexity performance of a decoding method for a polar code with (N, K) = (1024, 632) according to some implementations of the present disclosure.

The graph shown in FIG. 24 represents the following: 1) the WER of a conventional permutation decoding method (see "Perm-SC" in FIG. 24), and 2) the WER of a decoding method applying τ₁, τ₂, and L_{c} according to some implementations of the present disclosure (see "Proposed" in FIG. 24). In FIG. 24, P = 32, τ₁ = 0.2, τ₁ = 5.5, and L_{c} = 4. As illustrated in FIG. 24, it may be identified that, even when some implementations of the present disclosure are used, in which early decoding termination is performed for some decoding paths and/or only decoding path(s) having the largest minimum LLR value(s) are decoded, there is substantially no performance degradation compared to conventional permutation decoding.

FIG. 25 compares complexity performance using the above-described two metrics (see Equations 17 and 18). Referring to FIG. 25, when the SNR value is 5, the ratio of skipped paths is approximately 80%, and thus the ratio of the number of paths for which decoding is actually completed to the total number of permutation paths is approximately 20%. The graph of FIG. 25 illustrates that, even when at most 20% of all decoding paths are used from the perspective of decoding paths and data bits, the same performance as conventional permutation decoding that performs decoding for all decoding paths may be achieved.

It may be identified from the performance evaluations illustrated in FIGS. 24 and 25 that the decoding method according to some implementations of the present disclosure reduces the complexity of a conventional permutation decoding method in various channels.

According to some implementations of the present disclosure, decoding may be early terminated for path(s) having a high probability of SC decoding failure. In addition, according to some implementations of the present disclosure, since the decoder may achieve sufficient decoding reliability using top L_{c} most reliable paths, the number of decoding paths may be reduced, thereby increasing a decoding speed or reducing decoding complexity. Further, unlike distributed CRC which may not be used in permutation decoding, early decoding termination may also be performed for permutation decoding according to some implementations of the present disclosure.

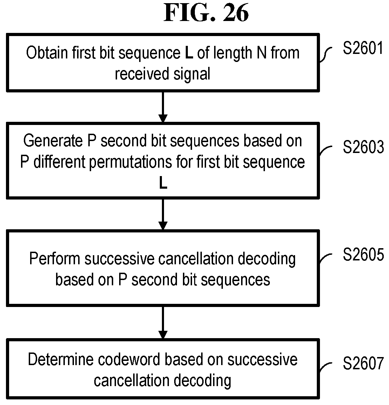

FIG. 26 illustrates a decoding flow according to some implementations of the present disclosure.

A communication device or decoder may perform operations related to channel decoding according to some implementations of the present disclosure. The communication device may include: at least one transceiver; at least one processor; and at least one computer memory operably connected to the at least one processor and storing instructions that, when executed, cause the at least one processor to perform operations according to some implementations of the present disclosure. A processing device for the communication device or decoder may include: at least one processor; and at least one computer memory operably connected to the at least one processor and storing instructions that, when executed, cause the at least one processor to perform the operations according to some implementations of the present disclosure. A computer-readable (non-volatile) storage medium may store at least one computer program including instructions that, when executed by at least one processor, cause the at least one processor to perform the operations according to some implementations of the present disclosure. A computer program or computer program product may include instructions that are recorded in at least one (non-volatile) computer-readable storage medium and cause, when executed, (at least one processor) to perform the operations according to some implementations of the present disclosure. In the communication device, the decoder, the processing device, the (non-transitory) computer-readable storage medium, and/or the computer program product, the operations may include: receiving a bit sequence **y** related to an encoded bit sequence of length N based on a polar code of size N, wherein N is an integer greater than 1; obtaining a first bit sequence of length N from the bit sequence **y** (S2601); generating P second bit sequences by applying P different permutations to the first bit sequence (S2603), wherein P is an integer greater than 1; performing successive cancellation decoding based on the P second bit sequences (S2605); and determining a codeword based on the successive cancellation decoding (S2607). Performing the successive cancellation decoding (S2607) may include completing decoding only for each of L_{c} second bit sequences having top-ranked minimum LLR values greater than a predetermined second threshold τ₂ among the P second bit sequences, wherein L_{c} is a positive integer smaller than P.

In some implementations, performing the successive cancellation decoding (S2607) may include terminating decoding for a second bit sequence, before completion of the decoding, when: i) a minimum LLR value among LLR values of t least reliable information bits is not greater than τ₂; or ii) the second bit sequence does not belong to the L_{c} second bit sequences.

In some implementations, performing the successive cancellation decoding (S2607) may include terminating decoding of a second bit sequence having an information bit with an LLR value smaller than a predefined first threshold τ₁ among the P second bit sequences, at the information bit having the LLR value smaller than τ₁.

In some implementations, performing the successive cancellation decoding (S2607) may include: comparing LLR values of t least reliable information bits in each of the P second bit sequences with τ₁; and terminating decoding of a corresponding second bit sequence at an information bit having an LLR value smaller than τ₁ among the t least reliable information bits.

In some implementations, t may be a positive integer satisfying BLERₙₛ ≅ BLERₗ, ${BLER}_{ns} = 1 - {\prod }_{i = 1}^{K} \left(1-{P}_{e _ i}\right)$ , *BLER*ₗ = 1 - ∏_{*i*∈*IT*}(1 - *P*_{*e*_*i*}(*τ*₁))), I_{T}= {1, 2, ..., t}, K is the number of information bits, and P_{e_i} is an error probability of an i^{th} bit among K information bits.

In some implementations, the encoded bit sequence may be obtained based on the K information bits and the polar code of size N.

In some implementations, the method may include determining an information bit sequence of length K based on the codeword and a polar sequence of length N that sorts N bit indices of the polar code of length N according to reliability.

In some implementations, performing the successive cancellation decoding (S2607) may include: outputting L_{c} third bit sequences based on the L_{c} second bit sequences; and outputting, as the codeword, a bit sequence minimizing a distance between the bit sequence **y** and a corresponding third bit sequence among the L_{c} third bit sequences.

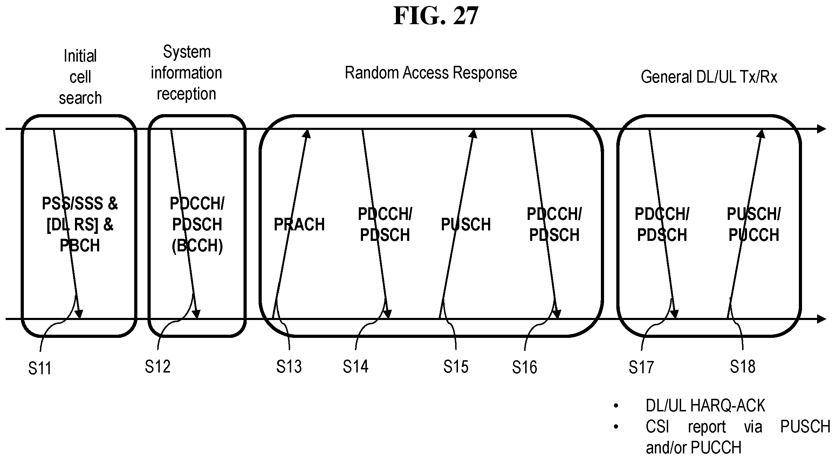

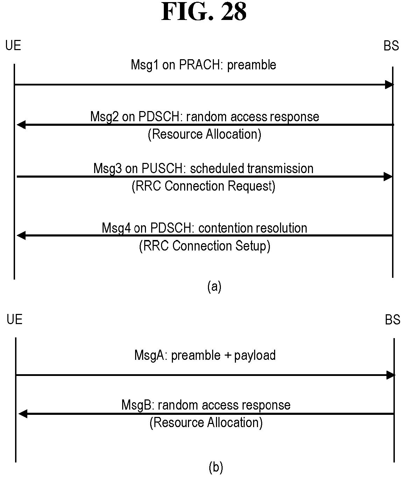

In some implementations of the present disclosure, the communication device or the decoder may establish an RRC connection for communication with another communication device (e.g., a UE or a BS), and receive a signal related to the first bit sequence having the length N from the other communication device. For example, based on a signal transmission/reception process described with reference to FIGS. 27 and 28, a signal including part or all of a bit sequence encoded with a polar code having a length N may be received from another communication device through a physical channel (e.g., a physical uplink control channel (PUCCH), a physical uplink shared channel (PUSCH), a physical downlink control channel (PDCCH), a physical downlink shared channel (PDSCH), a physical broadcast channel (PBCH), a physical sidelink control channel (PSCCH), a physical sidelink shared channel (PSSCH), or a physical sidelink broadcast channel (PSBCH)). The physical channel may carry a rate-matched codeword obtained by rate-matching a codeword (e.g., a codeword having a length N) for uplink control information (UCI), uplink shared channel (UL-SCH) data, a master information block (MIB), which is part of minimum system information, downlink control information (DCI), downlink shared channel (DL-SCH) data, or sidelink shared channel (SL-SCH) data. The communication device transmitting the rate-matched codeword or the encoder of the communication device may perform rate matching on the codeword based on radio resources allocated for transmission of the codeword and a target code rate for the physical channel, and may transmit the rate-matched codeword to a counterpart communication device as a transmission sequence. The communication device receiving the rate-matched codeword or the decoder of the communication device may obtain, from a received signal, the first bit sequence having the length N.

FIG. 27 is a diagram illustrating physical channels and a signal transmission/reception procedure using the physical channels in a 3GPP-based communication system as an exemplary wireless communication system.

When the UE is powered on or when the UE has been disconnected from the wireless communication system, the UE searches for a cell to camp on and performs initial cell search involving synchronization with a BS in the cell (S11). For the initial cell search, the UE receives a synchronization signal block (SSB) (also referred to as a SSB/PBCH block) from the BS. The SSB includes a primary synchronization signal (PSS), a secondary synchronization signal (SSS), and a physical broadcast channel (PBCH). The UE establishes synchronization with the BS based on the PSS/SSS and acquires information such as a cell identity (ID). The UE may acquire broadcast information in a cell based on the PBCH. The UE may receive a DL reference signal (RS) in an initial cell search procedure to monitor a DL channel status.

After initial cell search, the UE may camp on the cell. Subsequently, the UE may monitor a PDCCH in the cell and acquire more specific system information by receiving a PDSCH based on DCI carried on the PDCCH (S12).

Subsequently, to complete connection to the BS, the UE may perform a random access procedure (S13 to S16). In the random access procedure, for example, the UE may transmit a preamble on a PRACH (S13) and receive a PDCCH and a random access response (RAR) for the preamble on a PDSCH corresponding to the PDCCH (S14). When the UE fails in receiving the RAR directed to the UE, the UE may attempt to retransmit the preamble. In the case of contention-based random access, the UE may transmit a PUSCH based on a UL resource assignment included in the RAR (S15), and perform a contention resolution procedure including reception of a PDCCH and a PDSCH corresponding to the PDCCH (S16).

After the above procedure, the UE may receive a PDCCH/PDSCH from the BS (S17) and transmit a PUSCH/PUCCH to the BS (S19) in a general UL/DL signal transmission procedure. Control information that the UE transmits to the BS is generically called uplink control information (UCI). The UCI includes a hybrid automatic repeat and request acknowledgement/negative acknowledgement (HARQ ACK/NACK) (also referred to as HARQ-ACK), a scheduling request (SR), and channel state information (CSI). The CSI includes a channel quality indicator (CQI), a precoding matrix indicator (PMI), and/or a rank indication (RI). In general, UCI is transmitted on the PUCCH. However, when control information and data should be transmitted simultaneously, the control information may be transmitted on the PUSCH. In addition, the UE may transmit the UCI aperiodically on the PUSCH, upon receipt of a request/command from a network.

FIG. 28 illustrates random access procedures applicable to implementation(s) of the present disclosure. Particularly, FIG. 28(a) illustrates a 4-step random access procedure, and FIG. 28(b) illustrates a 2-step random access procedure.

A random access procedure may be used for various purposes including initial access, UL synchronization adjustment, resource allocation, handover, radio link reconfiguration after radio link failure, and positioning. Random access procedures are classified into a contention-based procedure and a dedicated (i.e., non-contention-based) procedure. The contention-based random access procedure generally involves initial access, whereas the dedicated random access procedure is used for UL synchronization reconfiguration in the event of handover, DL data arrival at a network, and positioning.

A configuration of a physical random access channel (PRACH) preamble to be used may be provided to the UE. A plurality of random access channel (RACH) preamble formats (i.e., PRACH preamble formats) are defined by one or more RACH orthogonal frequency division multiplexing (OFDM) symbols and different cyclic prefixes (CPs) (and/or guard periods). A PRACH preamble configuration for a cell provides the UE with PRACH preamble formats available on the cell and RACH occasion(s). A RACH occasion refers to time-frequency resources available for transmission/reception of random access (RA) preamble(s). In some scenarios, one RACH occasion (RO) is configured by a RRC message (e.g., SIB2 of the cell) for all possible RA preambles transmittable on the cell. In some other scenarios, SSBs may be selected in association with different beams, and an association between an SSB and a RACH occasion may be provided to the UE by the BS. SSBs associated with different DL beams of the cell may be identified by different SSB indices, and different SSB indices may represent different DL beams. The BS provides an available set of RACH occasions for transmission of an RA preamble and RACH occasion(s) associated with an SSB through a PRACH configuration including the PRACH preamble configuration. For example, the number of SSBs associated with one RACH occasion may be provided to the UE by a higher-layer (e.g., RRC) parameter SSB-perRACH-Occasion. Based on the PRACH configuration for the cell, each of SSBs transmitted on the cell is associated with one or more RACH occasions. The BS may provide the UE with the number of preambles per SSB through the PRACH configuration. For example, the number of preambles per SSB may be provided by a value of a higher-layer parameter cb-preamblePerSSB. The UE may determine the total number of preambles per SSB for each RACH occasion based on the value of SSB-perRACH-Occasion and the value of cb-preamblePerSSB. SSB indices may be mapped to RACH occasions in the following order:
- first, in an increasing order of preamble indices within a single RACH occasion;
- second, in an increasing order of frequency resource indices for frequency-multiplexed RACH occasions;
- third, in an increasing order of time resource indices for time-multiplexed RACH occasions within a RACH slot;
- fourth, in an increasing order of RACH slots.

In some scenarios in which SSBs are associated with different DL beams, the UE may detect one or more SSBs on a cell, select an SSB from among the detected SSBs (randomly or based on reference signal received power (RSRP)), and determine a RACH occasion associated with the selected SSB based on a PRACH configuration. The UE may transmit an RA preamble on the determined RACH occasion. The BS may monitor RACH occasions available on the cell. Based on a RACH occasion on which a RACH preamble is received, the BS may identify an SSB selected by the UE that transmits the RA preamble from among SSBs having different SSB indices transmitted by the BS on the cell. The BS may determine a DL beam suitable for the UE based on the SSB selected by the UE.

In the contention-based random access procedure, the UE selects a random access (RA) preamble. In the contention-based random access procedure, it is possible for a plurality of UEs to simultaneously transmit the same RA preamble, and thus a subsequent contention resolution process is required. In the dedicated random access procedure, the UE uses an RA preamble uniquely allocated to the UE by the BS. Therefore, the UE may perform the random access procedure without collision with other UEs.

Referring to FIG. 28(a), the contention-based random access procedure includes the following four steps. The messages transmitted in steps 1 to 4 may be referred to as message 1 (Msg1) to message 4 (Msg4), respectively.
- Step 1: The UE transmits an RA preamble on a PRACH.
- Step 2: The UE receives an RAR on a PDSCH from the BS.
- Step 3: The UE transmits UL data on a PUSCH to the BS. The UL data includes a Layer 2 (L2)/Layer 3 (L3) message.
- Step 4: The UE receives a contention resolution message on the PDSCH from the BS.

The UE may receive random access information in system information from the BS. When the UE needs random access, the UE transmits Msg1 (e.g., a preamble) on a PRACH to the BS. The BS may identify each RA preamble by a time/frequency resource (RA occasion (RO)) carrying the RA preamble, and a preamble index (PI). Upon receipt of the RA preamble from the UE, the BS transmits an RAR message to the UE on a PDSCH. To receive the RAR message, the UE monitors an L1/L2 control channel (PDCCH) with a cyclic redundancy check (CRC) masked with a random access- radio network temporary identifier (RA-RNTI), including scheduling information for the RAR message, within a preconfigured time window (e.g., ra-ResponseWindow). When receiving scheduling information on the PDCCH masked with the RA-RNTI, the UE may receive an RAR message on a PDSCH indicated by the scheduling information. The UE then checks whether there is an RAR directed to the UE in the RAR message. The presence or absence of the RAR directed to the UE may be determined by checking whether there is a random access preamble ID (RAPID) for the preamble transmitted by the UE. The index of the preamble transmitted by the UE may be identical to the RAPID. The RAR includes the index of the corresponding RA preamble, timing offset information (e.g., timing advance command (TAC)) for UL synchronization, UL scheduling information (e.g., UL grant) for Msg3 transmission, and UE temporary identification information (e.g., temporary-C-RNTI (TC-RNTI)). Upon receipt of the RAR, the UE transmits Msg3 on a PUSCH according to the UL scheduling information and the timing offset value in the RAR. Msg3 may include the ID (or global ID) of the UE. Further, Msg3 may include RRC connection request-related information (e.g., RRCSetupRequest message) for initial access to the network. After receiving Msg3, the BS transmits a contention resolution message, that is, Msg4 to the UE. When the UE receives the contention resolution message and succeeds in contention resolution, the TC-RNTI is changed to a C-RNTI. Msg4 may include the ID of the UE/RRC connection-related information (e.g., an RRCSetup message). When information transmitted in Msg3 does not match information received in Msg4 or when the UE has not received Msg4 for a predetermined time, the UE may determine that the contention resolution has failed and retransmit Msg3. When the UE succeeds in the contention resolution, the UE may transition to an RRC_CONNECTED state. For a UE in the RRC_CONNECTED state, RRC messages may be exchanged between an RRC layer of the UE and an RRC layer of the BS. That is, a UE in the RRC_CONNECTED state may refer to a UE with an established RRC connection to the BS.

The dedicated random access procedure includes the following three steps. Messages transmitted in step 0 to step 2 may be referred to as Msg0 to Msg2, respectively. The BS may trigger the dedicated random access procedure by a PDCCH serving the purpose of commanding RA preamble transmission (hereinafter, referred to as a PDCCH order).
- Step 0: The BS allocates an RA preamble to the UE by dedicated signaling.
- Step 1: The UE transmits the RA preamble on a PRACH.
- Step 2: The UE receives an RAR on a PDSCH from the BS.

Step 1 and step 2 of the dedicated random access procedure may be the same as step 1 and step 2 of the contention-based random access procedure.

A wireless communication system to be introduced in the future may require lower latency than the legacy system. Particularly for a latency-sensitive service such as URLLC, the 4-step random access procedure may not be preferable. A low-latency random access procedure may be needed for various scenarios in the NR system. When implementation(s) of the present disclosure are realized along with a random access procedure, the implementation(s) of the present disclosure may be carried out together with the following 2-step random access procedure to reduce latency involved in the random access procedure.

Referring to FIG. 28(b), the 2-step random access procedure may be performed in two steps: transmission of MsgA from the UE to the BS and transmission of MsgB from the BS to the UE. The MsgA transmission may include transmission of an RA preamble on a PRACH and transmission of UL payload on a PUSCH. In the MsgA transmission, the PRACH and the PUSCH may be transmitted in time division multiplexing (TDM). Alternatively, the PRACH and the PUSCH may be transmitted in frequency division multiplexing (FDM) in the MsgA transmission.

Upon receipt of MsgA, the BS may transmit MsgB to the UE. MsgB may include an RAR for the UE.

An RRC connection request-related message (e.g., RRCSetupRequest message) requesting establishment of a connection between the RRC layer of the BS and the RRC layer of the UE may be included in the payload of MsgA. In this case, MsgB may be used to transmit RRC connection-related information (e.g., RRCSetup message). In contrast, the RRC connection request-related message (e.g., RRCSetupRequest message) may be transmitted on a PUSCH based on a UL grant in MsgB. In this case, RRC connection-related information (e.g., RRCSetup message) related to the RRC connection request may be transmitted on a PDSCH associated with the PUSCH transmission after the PUSCH transmission based on MsgB.

When the UE successfully receives MsgB associated with MsgA transmitted by the UE, the UE may transition to the RRC_CONNECTED state. For a UE in the RRC_CONNECTED state, RRC messages may be exchanged between the RRC layer of the UE and the RRC layer of the BS. That is, a UE in the RRC_CONNECTED state may refer to a UE with an established RRC connection to the BS.

A communication device on the receiving side may receive RF signals at a carrier frequency through at least one antenna. In some implementations, the RF signals may include a signal related to an encoded bit sequence having a length N. For example, a method of the communication device or operations of the communication device may include: receiving a radio signal from another communication device through a physical channel on a serving cell of the communication device based on the random access procedure; performing frequency down-conversion on the received radio signal to obtain an OFDM baseband signal; obtaining complex-valued modulation symbols of the physical channel based on the OFDM baseband signal; and obtaining a first bit sequence having a length N based on the complex-valued modulation symbols of the physical channel. The first bit sequence having the length N may be decoded according to some implementations of the present disclosure.

The examples of the present disclosure as described above have been presented to enable any person of ordinary skill in the art to implement and practice the present disclosure. Although the present disclosure has been described with reference to the examples, those skilled in the art may make various modifications and variations in the example of the present disclosure. Thus, the present disclosure is not intended to be limited to the examples set forth herein, but is to be accorded the broadest scope consistent with the principles and features disclosed herein.

The implementations of the present disclosure may be used in a BS, a UE, or other equipment in a wireless communication system.

## Claims

1. A method of decoding a received signal by a communication device in a wireless communication system, the method comprising:
receiving a bit sequence **y** related to an encoded bit sequence of length N based on a polar code of size N, wherein N is an integer greater than 1;
obtaining a first bit sequence of length N from the bit sequence **y**;
generating P second bit sequences by applying P different permutations to the first bit sequence, wherein P is an integer greater than 1;
performing successive cancellation decoding based on the P second bit sequences; and
determining a codeword based on the successive cancellation decoding,
wherein performing the successive cancellation decoding includes:
completing decoding only for each of L_{c} second bit sequences having largest minimum log likelihood ratio (LLR) values greater than a predetermined second threshold τ₂ among the P second bit sequences, wherein L_{c} is a positive integer smaller than P.

2. The method of claim 1, wherein performing the successive cancellation decoding includes:
terminating decoding of a second bit sequence before completion of the decoding, when i) a minimum LLR value among LLR values of t least reliable information bits of the second bit sequence is not greater than τ₂, or ii) the second bit sequence does not belong to the L_{c} second bit sequences.

3. The method of claim 1, wherein performing the successive cancellation decoding includes:
terminating decoding of a second bit sequence including an information bit having an LLR value smaller than a predefined first threshold τ₁, among the P second bit sequences, at the information bit including the LLR value smaller than τ₁.

4. The method of claim 3, wherein performing the successive cancellation decoding includes:
comparing LLR values of t least reliable information bits in each of the P second bit sequences with τ₁; and
terminating decoding of a corresponding second bit sequence at an information bit having an LLR value smaller than τ₁ among the t least reliable information bits.

5. The method of claim 1, wherein the encoded bit sequence is obtained based on K information bits and the polar code of size N.

6. The method of claim 5, comprising:
determining an information bit sequence of length K based on the codeword and a polar sequence of length N that sorts N bit indices of the polar code of length N according to reliability.

7. The method of claim 1, wherein performing the successive cancellation decoding includes:
outputting L_{c} third bit sequences based on the L_{c} second bit sequences; and
outputting, as the codeword, a bit sequence minimizing a distance between the bit sequence **y** and a corresponding third bit sequence among the L_{c} third bit sequences.

8. A communication device for decoding a received signal in a wireless communication system, the communication device comprising:
at least one transceiver;
at least one processor; and
at least one computer memory operably connectable to the at least one processor and storing instructions which, when executed, cause the at least one processor to perform operations comprising:
receiving a bit sequence **y** related to an encoded bit sequence of length N based on a polar code of size N, wherein N is an integer greater than 1;
obtaining a first bit sequence of length N from the bit sequence **y**;
generating P second bit sequences by applying P different permutations to the first bit sequence, wherein P is an integer greater than 1;
performing successive cancellation decoding based on the P second bit sequences; and
determining a codeword based on the successive cancellation decoding, and
wherein performing the successive cancellation decoding includes:
completing decoding only for each of L_{c} second bit sequences having largest minimum log likelihood ratio (LLR) values greater than a predetermined second threshold τ₂ among the P second bit sequences, wherein L_{c} is a positive integer smaller than P.

9. A processing device in a wireless communication system, comprising:
at least one processor; and
at least one computer memory operably connectable to the at least one processor and storing instructions which, when executed, cause the at least one processor to perform operations comprising:
receiving a bit sequence **y** related to an encoded bit sequence of length N based on a polar code of size N, wherein N is an integer greater than 1;
obtaining a first bit sequence of length N from the bit sequence **y**;
generating P second bit sequences by applying P different permutations to the first bit sequence, wherein P is an integer greater than 1;
performing successive cancellation decoding based on the P second bit sequences; and
determining a codeword based on the successive cancellation decoding, and
wherein performing the successive cancellation decoding includes:
completing decoding only for each of L_{c} second bit sequences having largest minimum log likelihood ratio (LLR) values greater than a predetermined second threshold τ₂ among the P second bit sequences, wherein L_{c} is a positive integer smaller than P.

10. A computer-readable storage medium storing at least one program code including instructions which, when executed, cause at least one processor to perform operations comprising:
receiving a bit sequence **y** related to an encoded bit sequence of length N based on a polar code of size N a bit related to an encoded bit sequence of length N based on a polar code of size N, wherein N is an integer greater than 1;
obtaining a first bit sequence of length N from the bit sequence **y**;
generating P second bit sequences by applying P different permutations to the first bit sequence, wherein P is an integer greater than 1;
performing successive cancellation decoding based on the P second bit sequences; and
determining a codeword based on the successive cancellation decoding, and
wherein performing the successive cancellation decoding includes:
completing decoding only for each of L_{c} second bit sequences having largest minimum log likelihood ratio (LLR) values greater than a predetermined second threshold τ₂ among the P second bit sequences, wherein L_{c} is a positive integer smaller than P.
